# EUROPÄISCHE PATENTSCHRIFT

(11) **EP 3 320 359 B1**
(45) Veröffentlichungstag und Bekanntmachung des Hinweises auf die Patenterteilung: **22.09.2021**
(21) Anmeldenummer: 16738111.0
(22) Anmeldetag: 07.07.2016
(51) Int. Cl.: G01R 35/00, G01R 21/06, H02H 3/00, H02H 3/04

(54) **VERFAHREN UND PRÜFVORRICHTUNG ZUM PRÜFEN EINER VERDRAHTUNG VON WANDLERN**
METHOD AND TESTING DEVICE FOR TESTING WIRING OF TRANSFORMERS
PROCÉDÉ ET DISPOSITIF D'ESSAI POUR VÉRIFIER LE CÂBLAGE DE TRANSFORMATEURS

(30) Priorität: 07.07.2015 AT 505862015
(43) Veröffentlichungstag der Anmeldung: 16.05.2018
(73) Patentinhaber: Omicron electronics GmbH, 6833 Klaus (AT)
(72) Erfinder: KLAPPER, Ulrich, 6830 Rankweil (AT); KAISER, Steffen, 88138 Weissenberg (DE)
(74) Vertreter: Banzer, Hans-Jörg
(86) Internationale Anmeldenummer: PCT/EP2016/066100
(87) Internationale Veröffentlichungsnummer: WO 2017/005846

(56) Entgegenhaltungen:
- DE-A1- 10 048 962
- GB-A- 2 504 899

## Beschreibung

### GEBIET DER ERFINDUNG

Ausführungsbeispiele der Erfindung betreffen Vorrichtungen und Verfahren zum Prüfen von Einrichtungen elektrischer Energiesysteme, wie beispielsweise Vorrichtungen und Verfahren zum Prüfen einer Schutzeinrichtung, z.B. eines Schutzrelais. Ausführungsbeispiele der Erfindung betreffen insbesondere derartige Vorrichtungen und Verfahren, mit denen überprüft werden kann, ob ein oder mehrere Stromwandler sowie ein oder mehrere Spannungswandler einer Schutzeinrichtung oder einer anderen Sekundäreinrichtung korrekt eingebaut und angeschlossen sind und/oder ob Polaritätsfehler vorliegen.

Die Druckschrift GB 2 504 899 A beschreibt ein Erfassungssystem eines elektrischen Energiemesssystems mit drei Phasen eines elektrischen Verteilungsnetzes, welches einen elektrischen Energiemessprüfer, eine tragbare einstellbare Energiezufuhr mit drei Phasen, einen Dreiphasenspannungswandler, einen Dreiphasenstromwandler, einen standardisierten Dreiphasenspannungswandler und einen standardisierten Dreiphasenstromwandler umfasst. Dabei wird eine Spannung der tragbaren Energiezufuhr dem Dreiphasenspannungswandler und dem standardisierten Dreiphasenstromwandler und ein Strom der tragbaren Energiezufuhr dem Dreiphasenstromwandler und dem standardisierten Dreiphasenspannungswandler zugeführt.

Die Druckschrift DE 100 48 962 A1 offenbart eine tragbare Prüfeinrichtung zum Prüfen von mit hohen Spannungen und/oder Strömen zu betreibenden Prüflingen. Dabei wird dem Prüfling (z.B. einem Stromwandler oder einem Spannungswandler) über einen Anpassungstransformator ein gewünschtes Prüfsignal angelegt bzw. zugeführt. Es werden analoge Messsignale erfasst, welche sich während eines Prüfablaufs einstellen und bestimmte Messgrößen des Prüflings beschreiben.

### HINTERGRUND

Schutzeinrichtungen sind wichtige Komponenten elektrischer Energiesysteme. Derartige Schutzeinrichtungen können eingerichtet sein, um in einem Fehlerfall ein rasches Abschalten zu ermöglichen. Insbesondere im Mittel-, Hoch- und Höchstspannungsbereich können diese Schutzeinrichtungen Strom- und Spannungswandler umfassen, welche die Ströme und Spannungen des Primärsystems auf einfacher zu handhabende Niederspannungen transformieren.

Beispielhaft für derartige Schutzeinrichtungen ist ein Schutzrelais, das die Auswertung, ob ein Fehler vorliegt und welcher Art dieser Fehler ist, vornimmt, um eine Entscheidung zu treffen, ob, wie schnell und/oder in welchen Phasen ausgeschaltet werden soll. Das eigentliche Abschalten kann von Leistungsschaltern ausgeführt werden, beispielsweise Selbstblasschaltern, anderen gekapselten Leistungsschaltern oder nicht gekapselten Leistungsschaltern, die von dem Schutzrelais oder einer anderen Schutzeinrichtung gesteuert werden.

Eine wichtige Entscheidung im Hinblick auf den Einbau und die Funktionsweise einer derartigen Schutzeinrichtung ist die so genannte Vorwärts-Rückwärts-Entscheidung. Dadurch wird festgelegt, in welcher von zwei Richtungen die Schutzeinrichtung rascher abschaltet. Beispielsweise kann bei einem Fehler in einem ersten Leitungsabschnitt, z.B. eine Freileitung, rascher abgeschaltet werden als bei einem Fehler in einem auf der entgegengesetzten Seite der Schutzeinrichtung liegenden zweiten Leitungsabschnitt, der unmittelbar an einem Umspannwerk endet.

Ein Fehler, der "vor" der Schutzeinrichtung liegt, kann schneller abgeschaltet werden als ein Fehler, der "hinter" der Schutzeinrichtung liegt, da ein Abschalten eines hinter dem betrachteten Bereichs liegender Fehler keine sinnvolle Wirkung haben würde. Mit der Vorwärts-Rückwärts-Entscheidung wird festgelegt, in welche Richtung die Schutzeinrichtung gewissermaßen blickt, d.h. in welcher Richtung der Leitungsabschnitt liegt, für den bei Fehlerdetektion ein rascheres Abschalten im Fehlerfall erfolgt.

Beispielhaft kann ein Leitungsschutzrelais nach vorwärts auf eine Freileitung blicken. Hinter dem Leitungsschutzrelais könnte ein Umspannwerk liegen. Wäre der Fehler nahe vor dem Leitungsschutzrelais, also auf der Freileitung, müsste das Leitungsschutzrelais möglichst schnell abschalten. Läge der Fehler aber hinter dem Leitungsschutzrelais, also im Umspannwerk, z.B. in einem Trafo oder auf einer Sammelschiene, würde ein Abschalten nur wenig bewirken, da das Umspannwerk von vielen Signalquellen versorgt wird. Zum Schutz der Anlagenteile können andere Schutzrelais verwendet werden, beispielsweise ein Transformatordifferential oder ein Sammelschienenschutz.

Die Richtungsentscheidung, die angibt, in welche Richtung die Schutzeinrichtung schnell abschaltet, ist für die Funktionsweise besonders wichtig. Ist beispielsweise das oben bereits beschriebene Leitungsschutzrelais so installiert, dass es für die falsehe Richtung, würde die Schutzeinrichtung bei einem Fehler auf der Freileitung nicht abschalten. Eine fehlerhafte Richtungsentscheidung, die durch einen fehlerhaften Einbau oder eine fehlerhafte Verdrahtung verursacht werden kann, kann fatale Folgen für das gesamte elektrische System haben.

Eine Richtungsentscheidung der Schutzeinrichtung kann nur dann richtig getroffen werden, wenn die Strom- und vom Spannungswandler bis zum Schutzrelais richtig verdrahtet und eingestellt sind.

Es gibt zahlreiche Fehlerquellen, die zu einem falschen Richtungsentscheid führen können. Beispielsweise kann bei einem Stromwandler eine fehlerhafte Einbaurichtung des Stromwandlers, ein Polaritätsfehler des Stromwandlers, ein falscher Anschluss des Stromwandlers auf einer Sekundärseite, eine Vertauschung der beiden Leitungen zwischen dem Stromwandler und einem Schutzrelais, ein falscher Anschluss der Leitungen am Schutzrelais oder eine falsch eingestellte Einbaurichtung des Stromwandlers im Schutzrelais dazu führen, dass eine Schutzeinrichtung unbeabsichtigt in die falsche Richtung blickt, d.h. bei Fehlern in einem Leitungsabschnitt nicht ausreichend schnell abschaltet.

Alternativ oder zusätzlich kann ein falscher Richtungsentscheid auch durch einen falschen Einbau eines Spannungswandlers verursacht werden. Dies kann beispielsweise geschehen, wenn die Sekundärverdrahtung des Spannungswandlers auf dem Weg vom Spannungswandler zum Relais vertauscht ist.

Richtungsentscheide sind nicht nur für Schutzeinrichtungen, sondern auch für andere Einrichtungen elektrischer Energiesysteme relevant. Beispielsweise ist die Richtung eines Energieflusses relevant für Anzeigen in einer Warte. Nicht nur der Betrag der Energie ist wichtig, sondern auch die Richtung des Energieflusses ist für die Funktionsweise von Bedeutung. Ähnlich existieren Richtungsentscheidungen auch für Zähler, für die die Richtung des Energieflusses relevant ist.

Ein falscher Einbau, eine falsche Verdrahtung oder eine falsch eingestellte Einbaurichtung von Wandlern in der Sekundäreinrichtung, die die Ausgangssignale der Wandler weiter verarbeitet, kann zu Polaritätsfehlern führen.

Schutzeinrichtungen wie Schutzrelais, Zähler, Anzeigen in der Warte und ähnliche von Strom- und Spannungswandlern gespeiste Einrichtungen werden hier auch allgemein als Sekundäreinrichtungen bezeichnet, die über die Wandler transformierte Kenngrößen des Primärsystems erhalten.

Zum Prüfen von Teilen der Verdrahtung derartiger Sekundäreinrichtungen kann beispielsweise ein Strom an einer Primärseite eines Stromwandlers eingespeist und mit einem Mikroamperemeter oder einer anderen Messeinrichtung an der Sekundärseite des Stromwandlers die Polarität der Verdrahtung abgelesen werden. Derartige Techniken stellen hohe Anforderungen an das Prüfpersonal, können zu einer unerwünschten Aufmagnetisierung eines Wandlerkerns des Stromwandlers führen und können zahlreiche Fehlerquellen, beispielsweise einen falschen Anschluss des Stromwandlers an einem Schutzrelais, nicht erkennen.

Alternativ kann ein Wechselsignal in den Stromwandler eingeprägt werden. Mit einem auf das Wechselsignal abgestimmten Polaritätsdetektor kann die Polarität auf der Sekundärseite des Stromwandlers entlang der Verdrahtung und auch am Schutzrelais selbst überprüft werden. Auch diese Verfahren stellen relativ hohe Anforderungen an das Prüfpersonal und können beispielsweise fehlerhafte Verdrahtungen des Spannungswandlers nicht detektieren.

Darüber hinaus sind die genannten Verfahren zeitaufwändig.

### ZUSAMMENFASSUNG DER ERFINDUNG

Im Hinblick auf die genannten Nachteile herkömmlicher Verfahren besteht ein Bedarf an Vorrichtungen und Verfahren, mit denen die Betriebssicherheit von Einrichtungen der Energietechnik weiter erhöht werden kann. Es besteht insbesondere ein Bedarf an Vorrichtungen und Verfahren, mit denen ein fehlerhafter Einbau, eine Vertauschung von sekundärseitigen Drähten und/oder ein fehlerhafter Anschluss von Strom- oder Spannungswandlern in einfacher Weise detektiert werden kann.

Im Hinblick auf die genannten Nachteile herkömmlicher Verfahren wäre es insbesondere wünschenswert, die Verdrahtung zwischen Strom- und Spannungswandlern und einem Schutzrelais oder einer anderen Einrichtung des Sekundärsystems im Hinblick auf alle möglichen Polaritätsfehler zu überprüfen und alle mögliche Fehlerquellen mit einem einzigen Test, der einen oder mehrere Schritte umfassen kann, auszuschließen.

Erfindungsgemäß wird ein Verfahren gemäß Anspruch 1 zum Prüfen einer Verdrahtung eines Stromwandlers und eines Spannungswandlers einer Einrichtung eines elektrischen Energiesystems und eine Prüfvorrichtung gemäß Anspruch 11 vorgeschlagen. Die abhängigen Ansprüche definieren bevorzugte und/oder vorteilhafte Ausführungsformen der Erfindung.

Nach Ausführungsbeispielen werden Verfahren, Vorrichtungen und Systeme und angegeben, mit denen Polaritätsfehler detektierbar sind, welche bei der Verwendung von Strom- und Spannungswandlern bei Schutzeinrichtungen wie Schutzrelais, bei Energiezählern, bei Anzeigen in einer Warte oder bei anderen Einrichtungen energietechnischer Systeme bestehen können.

Nach Ausführungsbeispielen wird gleichzeitig ein erstes Prüfsignal an einer Sekundärseite eines Spannungswandlers, der mit einer Schutzeinrichtung oder einer anderen Einrichtung des Sekundärsystems verbunden ist, angelegt und ein zweites Prüfsignal in eine Primärseite eines Stromwandlers, der mit der Einrichtung Schutzeinrichtung oder der anderen Einrichtung des Sekundärsystems verbunden ist, eingeprägt. Eine Antwort der Einrichtung auf das erste Prüfsignal und das zweite Prüfsignal kann überwacht und mit einer simulierten, beispielsweise einer rechnerisch vorhergesagten, Antwort verglichen werden.

Nach Ausführungsbeispielen kann die Antwort der Einrichtung eine Leistung sein, die von der Schutzeinrichtung oder einer anderen Einrichtung des Sekundärsystems erfasst wird. Ein Vorzeichen und optional auch ein Betrag der erfassten Leistung können mit der rechnerisch ermittelten Leistung verglichen werden, die für die Phasenlagen der ersten und zweiten Prüfsignale und optional deren Amplituden erwartet wird.

Die Leistung, die als Antwort erfasst und/oder rechnerisch ermittelt wird, kann eine Wirkleistung sein oder umfassen. Alternativ oder zusätzlich kann die Leistung, die als Antwort erfasst und/oder rechnerisch ermittelt wird, eine Blindleistung sein oder umfassen.

Alternativ oder zusätzlich kann als Antwort eine Stromamplitude, eine Spannungsamplitude sowie ein Phasenwinkel zwischen Strom und Spannung, die von der Einrichtung erfasst und optional angezeigt werden, ausgewertet werden.

Ein Verfahren zum Prüfen einer Verdrahtung wenigstens eines Stromwandlers und wenigstens eines Spannungswandlers einer Einrichtung eines elektrischen Energiesystems wird nach einem Ausführungsbeispiel bereitgestellt. Das Verfahren umfasst ein Anlegen eines ersten Prüfsignals an einer Sekundärseite eines Spannungswandlers der Einrichtung und ein Einprägen eines zweiten Prüfsignals in eine Primärseite eines Stromwandlers der Einrichtung, wobei das erste Prüfsignal und das zweite Prüfsignal gleichzeitig erzeugt werden.

Durch das Verfahren wird eine Antwort der Einrichtung, beispielsweise bei einem Schutzrelais oder einer Anzeige in der Warte erzielt. Da es bei einem Stromwandler deutlich mehr Fehlerquellen für Polaritätsfehler als bei einem Spannungswandler gibt, wird nach Ausführungsbeispielen die Stromeinspeisung am Stromwandler primärseitig vorgenommen. Dies erlaubt, die Einbaurichtung und die Polarität des Stromwandlers sowie die sekundären Anschlussklemmen gemeinsam im gleichen Schritt mit zu überprüfen.

Das erste Prüfsignal und das zweite Prüfsignal können vorteilhaft gleichzeitig an einen Stromwandler und an die Sekundärverdrahtung eines Spannungswandlers bereitgestellt werden, die mit derselben Phase verbunden sind. Die Erzeugung von Prüfsignalen und die nachfolgende Auswertung einer Antwort auf die Prüfsignale kann für die Stromwandler und Spannungswandler der anderen Phasen wiederholt werden, um auch Verdrahtungsfehler an den anderen Phasen ausschließen zu können.

Das Verfahren umfasst ein Auswerten einer Antwort der Einrichtung auf das erste Prüfsignal und das zweite Prüfsignal.

Zum Auswerten der Antwort der Einrichtung kann eine erwartete Antwort aus einer Amplitude des ersten Prüfsignals, einer Amplitude des zweiten Prüfsignals und einer Phasenbeziehung zwischen dem ersten Prüfsignal und dem zweiten Prüfsignal simuliert werden. Die erwartete Antwort kann weiterhin von einem Übersetzungsverhältnis des Stromwandlers abhängen.

Die erwartete Antwort kann durch eine Prüfvorrichtung automatisch ermittelt und mit der Antwort der Einrichtung, die von der Prüfvorrichtung oder einem Benutzer erfasst werden kann, verglichen werden.

Die Antwort der Einrichtung kann eine von der Einrichtung erfasste Leistung umfassen. Dabei kann jedenfalls ein Vorzeichen der erfassten Leistung und optional auch der Betrag der erfassten Leistung dahingehend ausgewertet werden, ob diese mit dem für das erste Prüfsignal und das zweite Prüfsignal erwarteten Vorzeichen und/oder dem entsprechenden Betrag der Leistung übereinstimmen.

Das erste Prüfsignal kann eine Wechselspannung sein. Das erste Prüfsignal kann von einer ersten Signalquelle erzeugt werden, die in ein Prüfgerät integriert sein kann. Die erste Signalquelle kann eine steuerbare Spannungsquelle sein.

Das zweite Prüfsignal kann ein Wechselstrom sein. Das zweite Prüfsignal kann von einer zweiten Signalquelle erzeugt werden, die in das Prüfgerät integriert sein kann. Die zweite Signalquelle kann eine steuerbare Stromquelle sein.

Das erste Prüfsignal und das zweite Prüfsignal können gleichphasig sein. In diesem Fall sollte bei einer Verdrahtung, die keine Polaritätsfehler aufweist, eine Leistungsanzeige in Vorwärtsrichtung am Schutzrelais, im Zähler oder in der Warte resultieren. Aus einer Leistungsanzeige mit umgekehrtem Vorzeichen kann auf das Vorliegen eines Polaritätsfehlers in der Verdrahtung, einen falschen Einbau des Stromwandlers oder eine falsch eingestellte Einbaurichtung des Stromwandlers am Schutzrelais oder an der Warte geschlossen werden.

Das erste Prüfsignal kann an der Sekundärseite des Spannungswandlers angelegt werden, der einer ersten Phase von mehreren Phasen zugeordnet ist. Das zweite Prüfsignal kann in die Primärseite des Stromwandlers eingeprägt werden, der der ersten Phase zugeordnet ist.

Die Prüfung der Verdrahtung der Wandler unterschiedlicher Phasen kann zeitsequentiell oder überlappend erfolgen. Für eine zeitsequentielle Überprüfung kann das Erzeugen des ersten Prüfsignals und des zweiten Prüfsignals wiederholt werden, wobei jeweils das erste Prüfsignal an der Sekundärseite eines Spannungswandlers und das zweite Prüfsignal an der Primärseite des Stromwandlers derselben Phase eingeprägt werden.

Das Verfahren kann ein Erzeugen wenigstens eines weiteren Prüfsignals für wenigstens einen weiteren Wandler, der einer von der ersten Phase verschiedenen weiteren Phase einer Mehrphasenleitung zugeordnet ist, umfassen.

Das wenigstens eine weitere Prüfsignal kann gleichzeitig mit dem ersten Prüfsignal und dem zweiten Prüfsignal erzeugt werden. Dadurch kann die Prüfung der Verdrahtung der Wandler unterschiedlicher Phasen wenigstens teilweise zeitlich überlappend ausgeführt werden.

Das erste Prüfsignal und wenigstens ein weiteres Wechselspannungssignal können an der Sekundärseite von wenigstens zwei Spannungswandlern der Einrichtung, die unterschiedlichen Phasen zugeordnet sind, gleichzeitig angelegt werden. Dadurch kann die Prüfung der Verdrahtung der Wandler unterschiedlicher Phasen wenigstens teilweise zeitlich überlappend ausgeführt werden.

Das erste Prüfsignal und das wenigstens eine weitere Wechselspannungssignal können unterschiedliche Amplituden aufweisen. Dadurch wird die gleichzeitige Prüfung der Verdrahtung von Wandlern unterschiedlicher Phasen erleichtert, da anhand der Amplituden der erfassten Leistung eine Zuordnung zu den unterschiedlichen Phasen möglich ist.

Das zweite Prüfsignal und wenigstens ein weiteres Wechselstromsignal können an der Primärseite von wenigstens zwei Stromwandlern der Einrichtung, die unterschiedlichen Phasen zugeordnet sind, gleichzeitig angelegt werden. Dadurch kann die Prüfung der Verdrahtung der Wandler unterschiedlicher Phasen wenigstens teilweise zeitlich überlappend ausgeführt werden.

Das zweite Prüfsignal und das wenigstens eine weitere Wechselstromsignal können unterschiedliche Amplituden aufweisen. Dadurch wird die gleichzeitige Prüfung der Verdrahtung von Wandlern unterschiedlicher Phasen erleichtert, da anhand der Amplituden der erfassten Leistung eine Zuordnung zu den unterschiedlichen Phasen möglich ist.

Es können gleichzeitig Prüfsignale in die Primärseite von drei Stromwandlern und Prüfsignale in die Sekundärseite von drei Spannungswandlern der Einrichtung eingeprägt werden. Die Prüfsignale, die unterschiedlichen Phasen zugeordnet sind, können dabei jeweils unterschiedliche Amplituden aufweisen, um beispielsweise eine Vertauschung von Anschlüssen am Schutzrelais erkennen zu können. Die Prüfsignale, die unterschiedlichen Phasen zugeordnet sind, können jeweils eine Phasenverschiebung von 120° zueinander aufweisen.

Der wenigstens eine Spannungswandler kann für die Prüfung auf der Sekundärseite abgeklemmt werden, während das erste Prüfsignal an der Sekundärseite angelegt wird. Dadurch wird ein Hochtransformieren der Spannung verhindert, was einerseits einen erhöhten Leistungsbedarf zur Folge hätte und andererseits ein Sicherheitsrisiko in der energietechnischen Anlage darstellen würde.

Mit dem Verfahren kann die Verdrahtung mehrerer Strom- und Spannungswandler überprüft werden, die mit einem Schutzrelais verbunden sind.

Mit dem Verfahren kann überprüft werden, ob mehrere Strom- und Spannungswandler so eingebaut und verdrahtet wurden, dass ein Schutzrelais bei einem Fehler, der an einer vorgegebenen ersten Seite relativ zu dem Schutzrelais auftritt, schneller abschaltet als bei einem Fehler, der an einer zu der ersten Seite entgegengesetzten zweiten Seite relativ zu dem Schutzrelais auftritt.

Mit dem Verfahren kann überprüft werden, ob mehrere Stromwandler und ihre Verbindungen zu einer Sekundäreinrichtung, beispielsweise einem Schutzrelais, die korrekte Polarität aufweisen.

Die mehreren Strom- und Spannungswandler können ein Primärsystem, das ein System der Mittel- oder Hochspannungstechnik sein kann, mit der Einrichtung verbinden, die zum Sekundärsystem gehören kann, in dem niedrigere Spannungen vorliegen. Die mehreren Strom- und Spannungswandler können eingerichtet sein, um im Betrieb an die Einrichtung des Sekundärsystems Spannungen bereitzustellen, die kleiner sind als die Spannungen des Primärsystems, mit denen die Eingangsseiten der Stromwandler und der Spannungswandler verbunden sind.

Eine Prüfvorrichtung zum Prüfen einer Verdrahtung wenigstens eines Stromwandlers und wenigstens eines Spannungswandlers einer Einrichtung eines elektrischen Energiesystems wird nach einem weiteren Ausführungsbeispiel angegeben. Die Prüfvorrichtung umfasst einen ersten Ausgang zum Anlegen eines ersten Prüfsignals an eine Sekundärseite eines Spannungswandlers der Einrichtung und einen zweiten Ausgang zum Einprägen eines zweiten Prüfsignals in eine Primärseite eines Stromwandlers der Einrichtung, wobei die Prüfvorrichtung eingerichtet ist, um das an die Sekundärseite des Spannungswandlers angelegte erste Prüfsignal und das in die Primärseite des Stromswandlers eingeprägt zweite Prüfsignal gleichzeitig zu erzeugen.

Die Prüfvorrichtung kann eine elektronische Recheneinrichtung umfassen, die eingerichtet ist, um eine erwartete Antwort der Einrichtung auf das erste Prüfsignal und das zweite Prüfsignal aus einer Amplitude des ersten Prüfsignals, einer Amplitude des zweiten Prüfsignals und einer Phasenbeziehung zwischen dem ersten Prüfsignal und dem zweiten Prüfsignal rechnerisch zu ermitteln.

Die elektronische Recheneinrichtung kann eingerichtet sein, um wenigstens ein Vorzeichen einer von der Einrichtung als Antwort auf das erste Prüfsignal und das zweite Prüfsignal erfassten Leistung zu ermitteln.

Die elektronische Recheneinrichtung kann eingerichtet sein, um einen Betrag einer von der Einrichtung als Antwort auf das erste Prüfsignal und das zweite Prüfsignal erfassten Leistung zu ermitteln.

Die Prüfvorrichtung kann eine Ausgabeschnittstelle zum Ausgeben der rechnerisch ermittelten erwarteten Antwort umfassen. Beispielsweise kann ausgegeben werden, welches Vorzeichen eine von der Einrichtung ermittelte Leistung, die beispielsweise in einer Warte angezeigt wird, aufweisen wird, falls keine Verdrahtungsfehler oder sonstige Polaritätsfehler vorliegen. Abhängig von einem Vergleich des Vorzeichens der Leistung, die von der Einrichtung ermittelt wird, mit dem für die Prüfsignale erwarteten Vorzeichen der Leistung kann bestimmt werden, ob ein Verdrahtungsfehler oder Polaritätsfehler vorliegen.

Die Prüfvorrichtung kann eine Eingangsschnittstelle zum Empfangen der Antwort der Einrichtung umfassen. Beispielsweise kann die Prüfvorrichtung eingerichtet sein, um über die Eingangsschnittstelle ein Vorzeichen und optional auch einen Betrag einer von der Einrichtung als Antwort auf das erste und das zweite Prüfsignal ermittelten Leistung empfangen. Die Prüfvorrichtung kann eingerichtet sein, um die über die Eingangsschnittstelle empfangene Antwort der Einrichtung auf das erste Prüfsignal und das zweite Prüfsignal auszuwerten. Dazu kann die Prüfvorrichtung eingerichtet sein, um zu ermitteln, ob die empfangene Antwort ein Vorzeichen und optional einen Betrag aufweist, der konsistent mit der für das erste und zweite Prüfsignal erwarteten Antwort ist. Die Eingangsschnittstelle kann eine Benutzerschnittstelle sein oder umfassen, über die der Benutzer Information über die Antwort der Einrichtung eingeben kann.

Falls die Prüfvorrichtung für die Prüfung der Verdrahtung von Strom- und Spannungswandlern mehrerer Phasen eingerichtet ist, kann über die Ausgabeschnittstelle mehr als eine erwartete Antwort ausgegeben werden. Beispielsweise können die Vorzeichen und optional auch die Beträge von mehreren Leistungsanzeigen einer Warten, die als Antwort auf die Prüfsignale für mehrere Phasen erwartet werden, ausgegeben werden.

Falls die Prüfvorrichtung für die Prüfung der Verdrahtung von Strom- und Spannungswandlern mehrerer Phasen eingerichtet ist, kann über die Eingangsschnittstelle mehr als eine Antwort empfangen werden. Beispielsweise können die Vorzeichen und optional auch die Beträge von mehreren Leistungsanzeigen einer Warte, die als Antwort auf die Prüfsignale für mehrere Phasen erwartet werden, empfangen und von der Prüfvorrichtung weiter ausgewertet werden.

Die Prüfvorrichtung kann ein oder mehrere steuerbare Signalquellen umfassen, um das erste Prüfsignal und das zweite Prüfsignal zu erzeugen.

Die Signalquellen können so steuerbar sein, dass sie selektiv als Stromquelle und als Spannungsquelle betreibbar sind.

Die Prüfvorrichtung kann eine steuerbare Spannungsquelle zum Erzeugen des ersten Prüfsignals umfassen.

Die Prüfvorrichtung kann eine steuerbare Stromquelle zum Erzeugen des zweiten Prüfsignals umfassen.

Die Prüfvorrichtung kann eingerichtet sein, um das erste Prüfsignal und wenigstens ein weiteres Wechselspannungssignal gleichzeitig an der Sekundärseite von wenigstens zwei Spannungswandlern der Einrichtung, die unterschiedlichen Phasen zugeordnet sind, anzulegen.

Die Prüfvorrichtung kann eingerichtet sein, um das erste Prüfsignal und das wenigstens eine weitere Wechselspannungssignal so zu erzeugen, dass sie unterschiedliche Amplituden aufweisen.

Die Prüfvorrichtung kann eingerichtet sein, um das zweite Prüfsignal und wenigstens ein weiteres Wechselstromsignal gleichzeitig in die Primärseite von wenigstens zwei Stromwandlern der Einrichtung, die unterschiedlichen Phasen zugeordnet sind, einzuprägen.

Die Prüfvorrichtung kann eingerichtet sein, um das zweite Prüfsignal und das wenigstens eine weitere Wechselstromsignal so zu erzeugen, dass sie unterschiedliche Amplituden aufweisen.

Die Prüfvorrichtung kann als ein Prüfgerät ausgestaltet sein.

Das Prüfgerät kann ein mobiles, insbesondere ein portables Prüfgerät sein.

Die Prüfvorrichtung kann zur Durchführung des Verfahrens nach jedem der beschriebenen Ausführungsbeispiele eingerichtet sein.

Ein System nach einem Ausführungsbeispiel umfasst eine Einrichtung, die wenigstens einen Stromwandier und wenigstens einen Spannungswandler aufweist, und eine Prüfvorrichtung nach einem Ausführungsbeispiel, die mit der Sekundärseite eines Spannungswandlers und mit der Primärseite eines Stromwandlers verbunden ist.

Die Einrichtung kann eine Einrichtung eines Sekundärsystems sein, die über den wenigstens einen Stromwandler und den wenigstens einen Spannungswandler mit dem Primärsystem gekoppelt ist.

Die Einrichtung kann ein Schutzrelais, eine Leistungsanzeige einer Warte, einen Energiezähler oder eine andere Einrichtung umfassen.

Falls die Einrichtung ein Schutzrelais umfasst, kann mit der Prüfvorrichtung ermittelbar sein, ob alle Stromwandler und alle Spannungswandler derart eingebaut und verdrahtet sind, dass das Schutzrelais bei einem Fehlerfall, der in einer vorgegebenen Richtung relativ zu dem Schutzrelais auftritt, rascher abschaltet als bei einem Fehlerfall, der in der entgegengesetzten Richtung relativ zu dem Schutzrelais auftritt.

Falls die Einrichtung eine Leistungsanzeige einer Warte umfasst, kann mit der Prüfvorrichtung ermittelbar sein, ob alle Stromwandler und alle Spannungswandler derart eingebaut und verdrahtet sind, dass die Leistung für jede Phase jeweils mit dem korrekten Vorzeichen ermittelt wird.

Falls die Einrichtung einen Energiezähler umfasst, kann mit der Prüfvorrichtung ermittelbar sein, ob alle Stromwandler und alle Spannungswandler derart eingebaut und verdrahtet sind, dass die Richtung des Energieflusses von dem Energiezähler korrekt ermittelt wird.

Bei Vorrichtungen, Systemen und Verfahren nach Ausführungsbeispielen kann wenigstens das zweite Prüfsignal, das in die Primärseite des Stromwandlers eingespeist wird, mit zeitabhängig veränderlicher Amplitude und/oder Frequenz erzeugt werden. Auf diese Weise kann das Risiko einer Aufmagnetisierung des Wandlerkerns des Stromwandlers verringert werden und/oder der Wandlerkern kann entmagnetisiert werden. Falls die Frequenz des zweiten Prüfsignals zeitabhängig verändert wird, kann auch die Frequenz des ersten Prüfsignals entsprechend verändert werden, um eine Gleichphasigkeit zwischen erstem Prüfsignal, das an der Sekundärseite des Spannungswandlers angelegt wird, und zweitem Prüfsignal, das an der Primärseite des Stromwandlers derselben Phase eingespeist wird, sicherzustellen.

Vorrichtungen, Verfahren und Systeme nach Ausführungsbeispielen erlauben, die Verdrahtung und andere mögliche Polaritätsfehlerquellen, die zwischen Strom- und Spannungswandlern und einer Einrichtung eines Sekundärsystems existieren können, effizient zu überprüfen. Das Risiko, dass Polaritätsfehler bestehen, die die Funktionsfähigkeit des elektrischen Energiesystems beeinträchtigen können, kann verringert werden.

### KURZE BESCHREIBUNG DER FIGUREN

Die Erfindung wird nachfolgend unter Bezugnahme auf die Zeichnungen anhand bevorzugter Ausführungsformen näher erläutert. In den Zeichnungen bezeichnen identische Bezugszeichen identische Elemente.
Figur 1 zeigt ein System mit einer Vorrichtung nach einem Ausführungsbeispiel.
Figur 2 zeigt ein System mit einer Vorrichtung nach einem Ausführungsbeispiel.
Figur 3 zeigt ein System mit einer Vorrichtung nach einem Ausführungsbeispiel.
Figur 4 zeigt ein System mit einer Vorrichtung nach einem Ausführungsbeispiel.
Figur 5 zeigt ein System mit einer Vorrichtung nach einem Ausführungsbeispiel.
Figur 6 zeigt Wechselspannungssignale, die von Vorrichtungen und Verfahren nach Ausführungsbeispielen zur gleichzeitigen Prüfung mehrerer Phasen erzeugt werden können.
Figur 7 ist ein Flussdiagramm eines Verfahrens nach einem Ausführungsbeispiel.
Figur 8 ist ein Flussdiagramm eines Verfahrens nach einem Ausführungsbeispiel.
Figur 9 ist ein Flussdiagramm eines Verfahrens nach einem Ausführungsbeispiel.

### DETAILLIERTE BESCHREIBUNG VON AUSFÜHRUNGSBEISPIELEN

Nachfolgend wird die vorliegende Erfindung anhand bevorzugter Ausführungsformen unter Bezugnahme auf die Zeichnungen näher erläutert. In den Figuren bezeichnen gleiche Bezugszeichen gleiche oder ähnliche Elemente. Die Figuren sind schematische Darstellungen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und ihr Zweck dem Fachmann verständlich werden.

In den Figuren dargestellte Verbindungen und Kopplungen zwischen funktionellen Einheiten und Elementen können auch als indirekte Verbindung oder Kopplung implementiert werden. Eine Verbindung oder Kopplung kann drahtgebunden oder drahtlos implementiert sein.

Während Ausführungsbeispiele im Kontext von Stromwandlern und Spannungswandlern beschrieben werden, deren Ausgang mit einer Schutzeinrichtung, beispielsweise einem Schutzrelais, verbunden ist, können die Verfahren und Vorrichtungen auch für andere Einrichtungen insbesondere der Sekundärtechnik von elektrischen Energiesystemen verwendet werden, bei denen die richtige Polarität des Einbaus und der Verbindung zwischen Stromwandlern und der Einrichtung sowie die richtige Polarität der Verbindung zwischen Spannungswandlern und der Einrichtung für die korrekte Funktionsweise von Bedeutung sind. Beispiele für derartige Einrichtungen sind Zähler, andere Messeinrichtungen und Leistungsanzeigen, beispielsweise ein einer Warte.

Nachfolgend werden Vorrichtungen und Verfahren beschrieben, mit denen überprüft werden kann, dass die Verbindung zwischen Stromwandlern und einer Schutzeinrichtung oder einer anderen Einrichtung des Sekundärsystems sowie die Verbindung zwischen Spannungswandlern und der Schutzeinrichtung oder der anderen Einrichtung des Sekundärsystems korrekt ist und keinen Verdrahtungsfehler, d.h. keine Vertauschung der Anschlussleitungen, aufweist. Andere Polaritätsfehler, beispielsweise ein Einbau eines oder mehrere Stromwandler mit falscher Polarität oder eine in der Warte oder in dem Schutzrelais falsch eingestellte Polarität des Stromwandlers, können ebenfalls erkannt werden.

Zum Prüfen werden gleichzeitig ein erstes Prüfsignal an einer Sekundärseite eines Spannungswandlers und ein zweites Prüfsignal in eine Primärseite eines Stromwandlers bereitgestellt. Das erste Prüfsignal kann an der Sekundärverdrahtung zwischen dem Spannungswandler und der Sekundäreinrichtung angelegt werden, ohne dass es an beiden Ausgangsanschlüssen des Spannungswandlers anliegen muss. Unter einem Anlegen des ersten Prüfsignals "an der Sekundärseite des Spannungswandlers" wird ein Vorgang verstanden, bei dem das erste Prüfsignal an der Verdrahtung zwischen dem Spannungswandler und der Einrichtung angelegt wird.

Eine Antwort der Schutzeinrichtung, beispielsweise ein Vorzeichen und optional ein Betrag einer von der Schutzeinrichtung als Reaktion auf das erste Prüfsignal und das zweite Prüfsignal ermittelten Leistung, die eine Wirkleistung oder eine Blindleistung sein kann, kann ausgewertet werden, um zu überprüfen, ob sowohl der Stromwandler als auch der Spannungswandler so eingebaut und verdrahtet sind, dass keine Polaritätsfehler vorliegen. Die Antwort der Schutzeinrichtung kann mit einer rechnerisch ermittelten Antwort, beispielsweise mit einem von einer Prüfvorrichtung rechnerisch ermittelten Vorzeichen für die Leistung, die von der Schutzeinrichtung erfasst werden sollte, verglichen werden, um zu ermitteln, ob Verdrahtungsfehler, bei denen die Leitungen vertauscht wurden, oder andere Polaritätsfehler vorliegen. Alternativ oder zusätzlich kann als Antwort eine Stromamplitude, eine Spannungsamplitude sowie ein Phasenwinkel zwischen Strom und Spannung, die von der Einrichtung erfasst und optional angezeigt werden, ausgewertet werden.

Die Prüfung kann sequentiell oder gleichzeitig für Strom- und Spannungswandler durchgeführt werden, die unterschiedlichen Phasen, z.B. drei Phasen einer Dreiphasenleitung, zugeordnet sind, wie noch ausführlicher beschrieben wird.

Die Strom- und Spannungswandler weisen jeweils eine Primärseite und eine Sekundärseite auf. Die Primärseite ist dabei jeweils definiert als diejenige Seite, die mit dem Primärsystem, beispielsweise dem Mittel-, Hoch- oder Höchstspannungssystem verbunden ist. Die Sekundärseite ist jeweils definiert als diejenige Seite, die mit einer Einrichtung des Sekundärsystems, beispielsweise einer Schutzeinrichtung, einer Warte oder einem Zähler, verbunden ist. Die Sekundärseite jedes Wandlers kann jeweils galvanisch von der Primärseite getrennt sein.

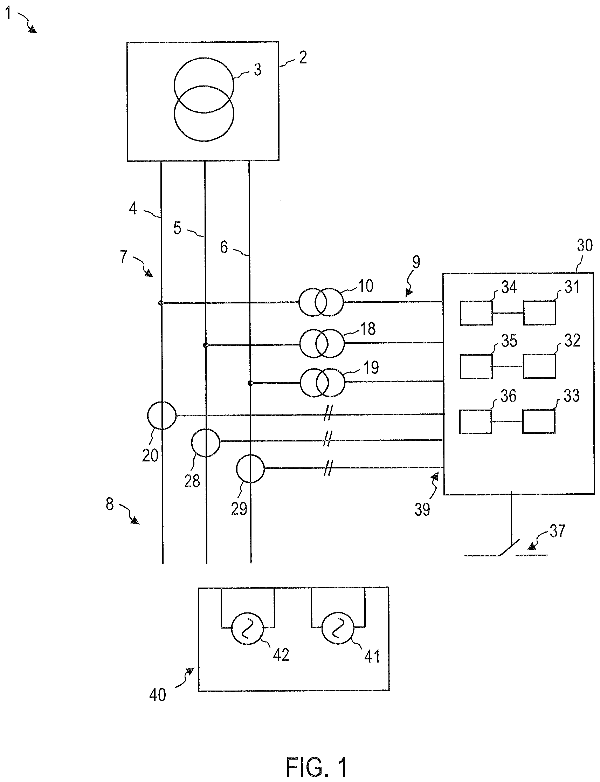

Figur 1 zeigt ein System 1 nach einem Ausführungsbeispiel. Das System 1 umfasst eine Schutzeinrichtung 30 in einem Sekundärsystem des elektrischen Energiesystems. Die Schutzeinrichtung 30 kann Eingänge 39 aufweisen, die über eine Verdrahtung 9 mit einem Spannungswandler oder mehreren Spannungswandlern 10, 18, 19 sowie mit einem Stromwandler oder mehreren Stromwandlern 20, 28, 29 leitend verbunden sind. Auch wenn schematisch jeweils nur eine Leitung dargestellt ist, versteht es sich, dass die Ausgänge der Wandler mit jeweils zwei Leitungen mit den Eingängen 39 der Schutzeinrichtung 30 verbunden sein können.

Die Schutzeinrichtung 30 kann ein Schutzrelais umfassen. Die Schutzeinrichtung 30 kann eingerichtet sein, um zur Detektion von Fehlerfällen, zum Überwachen eines Energieflusses oder für andere Zwecke die Ausgangssignale des wenigstens einen Spannungswandlers 10, 18, 19 und des wenigstens einen Stromwandlers 20, 28, 29 weiter zu verarbeiten.

Beispielsweise kann die Schutzeinrichtung 30 eine oder mehrere Schaltungen 34, 35, 36 umfassen, die eingerichtet sind, um aus den Ausgangssignalen des wenigstens einen Spannungswandlers 10, 18, 19 und des wenigstens einen Stromwandlers 20, 28, 29 eine im Primärsystem fließende Leistung zu ermitteln. Die Schutzeinrichtung 30 kann eine oder mehrere Schaltungen 34, 35, 36 umfassen, die eingerichtet sind, um aus den Ausgangssignalen des wenigstens einen Spannungswandlers 10, 18, 19 und des wenigstens einen Stromwandlers 20, 28, 29 zu ermitteln, ob ein Leistungsschalter 37 so angesteuert werden soll, dass eine Abschaltung erfolgt. Der Leistungsschalter 37 kann von einem Schutzrelais unterschiedlich angesteuert werden, abhängig davon, ob ein Fehler an einer ersten Seite 8 oder an einer dazu entgegengesetzten zweiten Seite 7 relativ zu der Stelle, an der die Schutzeinrichtung 30 über die Wandler mit dem Primärsystem gekoppelt ist, detektiert wird. Mit der Prüfvorrichtung 40 nach Ausführungsbeispielen kann überprüft werden, ob die Verdrahtung 9 und die Polarität der Stromwandler 20, 28, 29 derart gewählt ist, dass eine schnellere Abschaltung bei einem Fehlerfall erfolgt, der an einer vordefinierten ersten Seite 8 relativ zu der Schutzeinrichtung 30 vorliegt. Beispielsweise kann die erste Seite 8 diejenige Seite sein, an der eine Freileitung vorhanden ist, während die zweite Seite 7 diejenige Seite ist, an der in kurzer Entfernung ein Umspannwerk 2 liegt, dessen Transformator(en) 3 von einem oder mehreren Kraftwerken gespeist werden. Die Polaritätsentscheidung der Schutzeinrichtung 30, die festlegt, in welcher der beiden Richtungen eine raschere Abschaltung im Fehlerfall erfolgt, kann mit der Prüfvorrichtung 40 überprüft werden.

Die Schutzeinrichtung 30 kann eine oder mehrere Anzeigen 31, 32, 33 umfassen, die eine Leistung im Primärsystem anzeigen. Die Leistung kann abhängig davon, in welcher Richtung ein Energiefluss im Primärsystem erfolgt, mit positivem oder negativem Vorzeichen angezeigt werden. Die Richtungsentscheidung der Leistungsmessung, die angibt, in welcher Richtung der Leistungsfluss im Primärsystem als positive Leistung erfasst wird, hängt von der korrekten Verdrahtung 9 und dem korrekten Einbau der Stromwandler 20, 28, 29 ab. Diese Richtungsentscheidung der Leistungserfassung, die festlegt, in welcher der beiden Richtungen ein Energiefluss im Primärsystem als positive Leistung erfasst wird, kann mit der Prüfvorrichtung 40 überprüft werden. Dies gilt ebenso, wenn die Leistungserfassung unabhängig von einer Schutzeinrichtung 30 erfolgt, beispielsweise an einer Anzeige in einer Warte.

Anstelle oder zusätzlich zur Schutzeinrichtung 30 kann auch ein Zähler mit Ausgängen der Wandler gekoppelt sein. Ein erfasster Energiefluss kann abhängig davon, in welcher Richtung der Energiefluss im Primärsystem erfolgt, mit positivem oder negativem Vorzeichen gezählt werden. Die Richtungsentscheidung des Zählers, die angibt, in welcher Richtung der Energiefluss im Primärsystem zu einer Inkrementierung der erfassten Energie führt, hängt von der korrekten Verdrahtung 9 und dem korrekten Einbau der Stromwandler 20, 28, 29 ab. Diese Richtungsentscheidung des Zählers, die festlegt, in welcher der beiden Richtungen ein Energiefluss im Primärsystem zu einer Erhöhung der gezählten Energie führt, kann mit der Prüfvorrichtung 40 überprüft werden.

Die Prüfvorrichtung 40 ist eingerichtet, um gleichzeitig Wechselsignale an die Sekundärseite eines Spannungswandlers und die Primärseite des Stromwandlers, der derselben Phase wie der Spannungswandler zugeordnet ist, bereitzustellen.

Die Prüfvorrichtung 40 weist einen ersten Ausgang zur Verbindung mit der Sekundärseite eines Spannungswandlers 10, der einer Phase 4 zugeordnet ist, auf. Die Prüfvorrichtung kann eine erste Signalquelle 41 aufweisen, um über den ersten Ausgang ein erstes Prüfsignal an der Sekundärseite des Spannungswandlers 10 anzulegen, der der Phase 4 zugeordnet ist. Die erste Signalquelle 41 kann eine Wechselspannungsquelle sein. Die erste Signalquelle 41 kann so steuerbar sein, dass sie wahlweise als Spannungsquelle oder als Stromquelle betreibbar ist. Das erste Prüfsignal kann ein Wechselspannungssignal sein.

Die Prüfvorrichtung 40 weist einen zweiten Ausgang zur Verbindung mit der Sekundärseite eines Stromwandlers 20, der der Phase 4 zugeordnet ist, auf. Die Prüfvorrichtung kann eine zweite Signalquelle 42 aufweisen, um über den zweiten Ausgang ein zweites Prüfsignal an der Primärseite des Stromwandlers 20 einzuspeisen, der der Phase 4 zugeordnet ist. Die zweite Signalquelle 42 kann eine Wechselstromquelle sein. Die zweite Signalquelle 42 kann so steuerbar sein, dass sie wahlweise als Spannungsquelle oder als Stromquelle betreibbar ist.

Die erste Signalquelle 41 und die zweite Signalquelle 42 können als separate Einheiten ausgebildet sein. Alternativ kann ein Ausgangssignal derselben Signalquelle über unterschiedliche Schaltungen sowohl der Sekundärseite des Spannungswandlers 10 als auch der Primärseite des Stromwandlers 20 derselben Phase 4 zugeführt werden. Die erste Signalquelle 41 und die zweite Signalquelle 42 können in einem Gehäuse eines Prüfgeräts angeordnet sein oder können in separaten Gehäusen angeordnet werden.

Die Prüfvorrichtung 40 kann eingerichtet sein, um eine Prüfung, bei der ein erstes Prüfsignal an die Sekundärseite eines Spannungswandlers und eine zweites Prüfsignal an die Primärseite des Stromwandlers derselben Phase angelegt werden, zeitsequentiell für die mehreren Phasen 4, 5, 6 auszuführen. Die Prüfvorrichtung 40 kann Anschlüsse umfassen, die eingerichtet sind, um die Prüfvorrichtung 40 gleichzeitig mit den Primärseiten mehrerer Stromwandler 20, 28, 29, die unterschiedlichen Phasen 4, 5, 6 zugeordnet sind, und mit den Sekundärseiten mehrerer Spannungswandler 10, 18, 19, die unterschiedlichen Phasen 4, 5, 6 zugeordnet, zu verbinden.

Die Prüfvorrichtung 40 kann eine elektrisch steuerbare Anordnung von Schaltern umfassen, die eingerichtet ist, um die erste Signalquelle 41 mit der Sekundärseite unterschiedlicher Spannungswandler 10, 18, 19 zu verbinden, ohne dass hierzu eine Umverdrahtung zwischen der Prüfvorrichtung 40 und den Spannungswandlern 10, 18, 19 vorgenommen werden muss. Die Prüfvorrichtung 40 kann eine elektrisch steuerbare Anordnung von Schaltern umfassen, die eingerichtet ist, um die zweite Signalquelle 42 mit der Primärseite unterschiedlicher Stromwandler 20, 28, 29 zu verbinden, ohne dass hierzu eine Umverdrahtung zwischen der Prüfvorrichtung 40 und den Stromwandlern 20, 28, 29 vorgenommen werden muss.

Alternativ oder zusätzlich kann die Prüfvorrichtung 40 eingerichtet sein, um gleichzeitig Wechselspannungssignale gleicher oder unterschiedlicher Amplitude an die Sekundärseiten von wenigstens zwei Spannungswandlern 10, 18, 19 anzulegen und um gleichzeitig Wechselstromsignale gleicher oder unterschiedlicher Amplitude an die Primärseiten von wenigstens zwei Stromwandlern 20, 28, 29 anzulegen.

Beispielsweise kann ein erstes Wechselspannungssignal an der Sekundärseite eines Spannungswandlers 10, der einer ersten Phase 4 zugeordnet ist, angelegt werden, während ein zweites Wechselspannungssignal an der Sekundärseite eines weiteren Spannungswandlers 18, 19, der einer von der ersten Phase 4 verschiedenen weiteren Phase 5, 6 zugeordnet ist, angelegt wird. Gleichzeitig kann ein erstes Wechselstromsignal in die Primärseite eines Stromwandlers 10, der der ersten Phase 4 zugeordnet ist, eingespeist werden, während ein zweites Wechselstromsignal in die Primärseite eines weiteren Stromwandlers 18, 19, der der von der ersten Phase 4 verschiedenen weiteren Phase 5, 6 zugeordnet ist, eingespeist wird. Das erste Wechselspannungssignal ist eine Implementierung des ersten Prüfsignals, und das erste Wechselstromsignal ist eine Implementierung des zweiten Prüfsignals.

Das zweite Wechselspannungssignal kann eine andere Amplitude aufweisen als das erste Wechselspannungssignal. Alternativ oder zusätzlich kann das zweite Wechselstromsignal eine andere Amplitude aufweisen als das erste Wechselstromsignal. Die Prüfvorrichtung 40 kann so eingerichtet sein, dass ein Produkt der Amplitude des ersten Wechselspannungssignal und der Amplitude des ersten Wechselstromsignals verschieden ist von einem Produkt der Amplitude des zweiten Wechselspannungssignal und der Amplitude des zweiten Wechselstromsignals.

Die Prüfvorrichtung 40 kann so eingerichtet sein, dass das erste Wechselspannungssignal und das zweite Wechselspannungssignal eine erste Phasenverschiebung relativ zueinander aufweisen. Die Prüfvorrichtung 40 kann so eingerichtet sein, dass das erste Wechselstromsignal und das zweite Wechselstromsignal eine zweite Phasenverschiebung relativ zueinander aufweisen. Die Prüfvorrichtung 40 kann so eingerichtet sein, dass die zweite Phasenverschiebung gleich der ersten Phasenverschiebung ist. Die Prüfvorrichtung 40 kann so eingerichtet sein, dass die erste und die zweite Phasenverschiebung beide gleich +120° sind oder beide gleich -120° sind.

Die Prüfvorrichtung 40 kann eingerichtet sein, um eine Antwort der Schutzeinrichtung 30 oder der anderen Einrichtung des Sekundärsystems auf das erste Prüfsignal und das zweite Prüfsignal zu simulieren. Dazu kann beispielsweise die Prüfvorrichtung 40 ermitteln, welche Leistung von der Schutzeinrichtung 30 erfasst werden sollte. Die Prüfvorrichtung 40 kann eingerichtet sein, um abhängig von der Phasenlage zwischen dem ersten Prüfsignal, das an der Sekundärseite des Spannungswandlers 10 angelegt wird, und dem zweiten Prüfsignal, das in die Primärseite des derselben Phase 4 zugeordneten Stromwandlers 20 eingespeist wird, wenigstens ein Vorzeichen einer von der Schutzeinrichtung 30 erfassten Leistung zu ermitteln. Die Prüfvorrichtung 40 kann eingerichtet sein, um abhängig von der Phasenlage zwischen dem ersten Prüfsignal, das an der Sekundärseite des Spannungswandlers 10 angelegt wird, und dem zweiten Prüfsignal, das in die Primärseite des derselben Phase 4 zugeordneten Stromwandlers 20 eingespeist wird, zu ermitteln, ob das Schutzrelais den Leistungsschalter 37 rascher oder weniger rasch abschalten sollte, d.h. ob das Schutzrelais das erste Prüfsignal und das zweite Prüfsignal einem Fehlerfall auf der ersten Seite 8 oder der entgegengesetzten zweiten Seite 7 relativ zu dem Schutzrelais 30 zuordnet.

Die Prüfvorrichtung 40 kann eingerichtet sein, um die Amplituden des ersten und des zweiten Prüfsignals und optional auch Kenngrößen wenigstens des Spannungswandlers 10 bei der rechnerischen Ermittlung der erwarteten Antwort der Schutzeinrichtung 30 zu berücksichtigen. Beispielsweise kann aus dem Produkt der Amplituden des ersten und des zweiten Prüfsignals und dem Übersetzungsverhältnis des Spannungswandlers 10 ermittelt werden, welchen Betrag die von der Schutzeinrichtung 30 erfasste Leistung aufweisen sollte. Das Übersetzungsverhältnis des Spannungswandlers 10 kann benutzerdefiniert über eine Schnittstelle der Prüfvorrichtung 40 eingebbar sein und/oder kann für jeden von mehreren Spannungswandlern nichtflüchtig in einem Speicher der Prüfvorrichtung 40 gespeichert sein.

Ein Vergleich der von der Prüfvorrichtung 40 rechnerisch ermittelten erwarteten Antwort und der tatsächlichen Antwort der Schutzeinrichtung 30 kann automatisch durch die Prüfvorrichtung 40 erfolgen. Dazu kann die Prüfvorrichtung 40 eine Schnittstelle zur Verbindung mit der Schutzeinrichtung 30 aufweisen, über die die Antwort der Schutzeinrichtung 30 auf das erste Prüfsignal und das zweite Prüfsignal ausgelesen werden kann. Der Vergleich der von der Prüfvorrichtung 40 rechnerisch ermittelten erwarteten Antwort und der tatsächlichen Antwort der Schutzeinrichtung 30 kann auch durch einen Benutzer erfolgen.

Jeder Spannungswandler, an dessen Sekundärseite das erste Prüfsignal angelegt wird, kann während der Prüfung jeweils an der Sekundärseite abgeklemmt werden. Die für die Prüfung insgesamt benötigte Leistung kann dadurch gering gehalten werden.

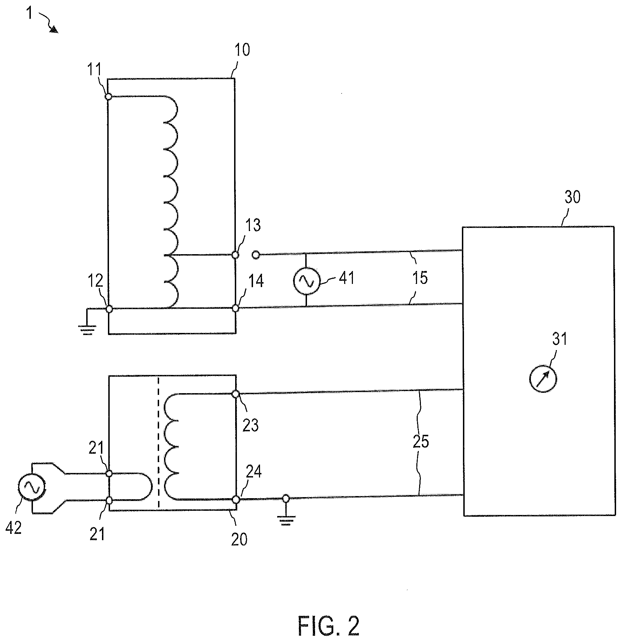

Die Funktionsweise und weitere Merkmale der Prüfvorrichtung 40 nach Ausführungsbeispielen werden unter Bezugnahem auf Figur 2 bis Figur 9 weiter beschrieben.

Figur 2 ist eine Darstellung eines Systems 1 nach einem Ausführungsbeispiel. Ein Spannungswandler 10 und ein Stromwandler 20 sind eingangsseitig mit derselben Phase gekoppelt, beispielsweise einer vorgegebenen Phase 4 einer Dreiphasenleitung.

Ausgangsanschlüsse 13, 14 an der Sekundärseite des Spannungswandlers 10 sind mit Eingängen einer Sekundäreinrichtung 30 über Leitungen 15 verbunden. Ein Eingangsanschluss 11 des Spannungswandlers 10 kann mit der Phase 4 verbunden sein. Der Spannungswandler 10 weist darüber hinaus einen eingangsseitigen Masseanschluss 12 auf.

Ausgangsanschlüsse 23, 24 an der Sekundärseite des Stromwandlers 20 sind mit weiteren Eingängen der Sekundäreinrichtung 30 über weitere Leitungen 25 verbunden. Eingangsanschlüsse 21, 22 des Spannungswandlers 20 können mit derselben Phase 4 verbunden sein, mit der auch der Eingangsanschluss 11 des Spannungswandlers 10 verbunden ist.

Die Sekundäreinrichtung 30 ist eine Einrichtung des Sekundärsystems eines elektrischen Energiesystems. Die Sekundäreinrichtung kann beispielsweise eine Leittechnikanzeige, ein Schutzrelais oder eine Messeinrichtung (Zähler) umfassen. Eine Anzeige 31 der Sekundäreinrichtung 30 kann eine von der Sekundäreinrichtung 30 erfasste Leistung anzeigen.

Die Prüfvorrichtung weist eine Spannungsquelle 41 auf, die mit der Sekundärverdrahtung 15 des Spannungswandlers 10 verbindbar ist, um ein erstes Prüfsignal an der Sekundärseite des Spannungswandlers 10 einzuspeisen. Der Spannungswandler 10 kann bei der Prüfung an der Sekundärseite 13 abgeklemmt sein, so dass das erste Prüfsignal 41 nicht zwischen den Ausgangsanschlüssen 13, 14 des Spannungswandlers 10 anliegt, sondern nur die Verdrahtung hin bis zur Sekundäreinrichtung 30 überprüft wird.

Die Prüfvorrichtung 40 weist eine Stromquelle 42 auf, die mit der Primärseite des Stromwandlers 20 verbindbar ist. Die Stromquelle 42 kann für eine Verbindung mit den Eingangsanschlüssen 21, 22 des Stromwandlers 20 eingerichtet sein. 15 des Spannungswandlers 10 verbindbar ist, um ein erstes Prüfsignal an der Sekundärseite des Spannungswandlers 10 einzuspeisen. Der Spannungswandler 10 kann bei der Prüfung an der Sekundärseite 13 abgeklemmt sein, so dass das erste Prüfsignal 41 nicht zwischen den Ausgangsanschlüssen 13, 14 des Spannungswandlers 10 anliegt, sondern nur die Verdrahtung hin bis zur Sekundäreinrichtung 30 überprüft wird.

Die Spannungsquelle 41 und die Stromquelle 42 können in separaten, unabhängig voneinander beweglichen Prüfgeräten enthalten sein. In diesem Fall erfolgt vorteilhaft eine Kommunikation zwischen den beiden Geräten, mit der sichergestellt wird, dass das von der Stromquelle 42 erzeugte zweite Prüfsignal in einer gewünschten Phasenbeziehung zu dem von der Spannungsquelle 41 erzeugten ersten Prüfsignal steht. Beispielsweise kann durch die Kommunikation zwischen den Prüfgeräten sichergestellt werden, dass das erste Prüfsignal und das zweite Prüfsignal gleichphasig sind. Eine elektronische Steuereinrichtung in einem der Prüfgeräte kann die Abstimmung der Phasenlage zwischen dem von der Stromquelle 42 erzeugten zweiten Prüfsignal und dem von der Spannungsquelle 41 erzeugten ersten Prüfsignal sicherstellen. Dazu kann die elektronische Steuereinrichtung, die als Prozessor oder Controller ausgestaltet sein kann, Steuersignale zu dem jeweils anderen Prüfgerät senden, die von diesem ausgewertet werden, um eine vordefinierte Phasenlage zwischen dem ersten Prüfsignal und dem zweiten Prüfsignal zu erzeugen. Die unterschiedlichen Prüfgeräte können eine Schnittstelle aufweisen, die den Austausch von Synchronisationsinformation zur Synchronisation erlaubt. Zum Bereitstellen der Spannungsquelle 41 und der Stromquelle 42 können zwei Transformatoren mit derselben Netzleitung verbunden werden, um eine Spannungsquelle 41 und eine Stromquelle 42 mit fester Phasenbeziehung zu erhalten.

Abhängig von einer Antwort der Sekundäreinrichtung 30, beispielsweise abhängig von einem Vorzeichen einer Leistungsanzeige auf der Anzeigeeinrichtung 31, kann überprüft werden, dass der Stromwandler 20 mit korrekter Polarität eingebaut ist, die Verdrahtungsleitungen 15 zwischen dem Spannungswandler 10 und den Eingängen der Sekundäreinrichtung 30 richtig, insbesondere ohne unbeabsichtigte Vertauschung, geführt sind und die weiteren Verdrahtungsleitungen 25 zwischen dem Stromwandler 20 und den Eingängen der Sekundäreinrichtung 30 richtig, insbesondere ohne unbeabsichtigte Vertauschung, geführt sind.

Die Prüfvorrichtung kann eingerichtet sein, um die korrekte Verdrahtung von Stromund Spannungswandlern zeitsequentiell oder gleichzeitig für Strom- und Spannungswandler auszuführen, die unterschiedlichen Phasen zugeordnet sind. Hierzu kann die Prüfvorrichtung zur gleichzeitigen Erzeugung von mehr als zwei Prüfsignalen ausgestaltet sein, und/oder kann zeitsequentiell ein erstes Prüfsignal und ein zweites Prüfsignal an die Wandler unterschiedlicher Phasen anlegen, wie dies unter Bezugnahme auf Figur 1 beschrieben wurde.

Die Prüfvorrichtung kann eine elektronische Recheneinrichtung umfassen, die als Prozessor, Controller, Mikroprozessor oder andere integrierte Halbleiterschaltung ausgestaltet sein kann. Die elektronische Recheneinrichtung kann eingerichtet sein, um eine Antwort der Sekundäreinrichtung auf das erste Prüfsignal und das zweite Prüfsignal rechnerisch zu ermitteln. Dazu kann das Verhalten der Sekundäreinrichtung 30 simuliert werden. Falls beispielsweise eine Berechnung einer Leistung durch die Sekundäreinrichtung 30 erfolgt, kann aus der Phasendifferenz zwischen dem zweiten Prüfsignal und dem ersten Prüfsignal vorhergesagt werden, welches Vorzeichen die erfasste Leistung bei korrekter Sekundärverdrahtung aufweisen muss. Aus den Amplituden des ersten und des zweiten Prüfsignals, der Phasendifferenz zwischen dem zweiten Prüfsignal und dem ersten Prüfsignal und dem Übersetzungsverhältnis des Stromwandlers 20 kann der Betrag der Leistung vorhergesagt werden.

Die elektronische Recheneinrichtung kann alternativ oder zusätzlich andere Berechnungen ausführen. Beispielsweise kann abhängig von dem ersten Prüfsignal, dem zweiten Prüfsignal und Information über den Typ eines Schutzrelais, die benutzerdefiniert eingebbar ist, ermittelt werden, ob das Schutzrelais als Reaktion auf das erste Prüfsignal und das zweite Prüfsignal bei korrekter Sekundärverdrahtung der Wandler einen Schutzschalter betätigen sollte. Optional kann abhängig von dem ersten Prüfsignal, dem zweiten Prüfsignal und Information über den Typ eines Schutzrelais, die benutzerdefiniert eingebbar ist, ermittelt werden, wie rasch das Schutzrelais auslösen sollte. Die Auslösezeit des Schutzrelais als Reaktion auf das erste Prüfsignal und das zweite Prüfsignal kann mit der rechnerisch ermittelten Antwort verglichen werden.

Weitere Ausgestaltungen und Merkmale der Prüfvorrichtung und des Systems von Figur 2 können den unter Bezugnahme auf Figur 1 beschriebenen Merkmalen entsprechen.

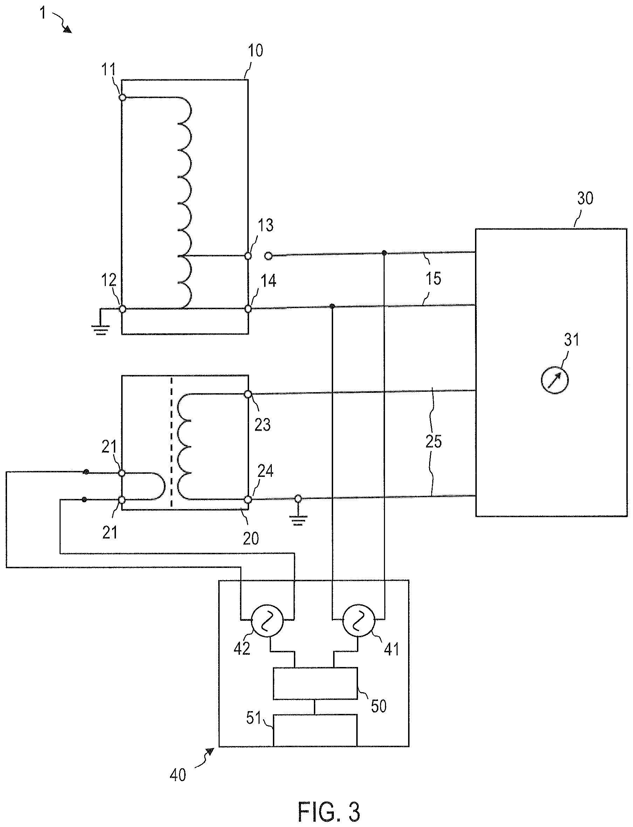

Figur 3 ist eine Darstellung eines Systems 1 nach einem Ausführungsbeispiel, das eine als Prüfgerät ausgestaltete Prüfvorrichtung 40 umfasst, die mit der Primärseite eines Stromwandlers 20 und der Sekundärverdrahtung eines Spannungswandlers 10 leitend verbunden ist. Merkmale, die unter Bezugnahme auf Figur 1 und Figur 2 beschriebene Ausgestaltungen und Wirkungen aufweisen können, sind mit denselben Bezugszeichen wie in Figur 1 und Figur 2 bezeichnet.

Die Prüfvorrichtung 40 umfasst die erste Signalquelle 41, die eine Wechselspannungsquelle sein kann, und die zweite Signalquelle 42, die eine Wechselstromquelle sein kann. Die erste Signalquelle 41 und die zweite Signalquelle 42 können in demselben Gehäuse der Prüfvorrichtung 40 untergebracht sein. Die Prüfvorrichtung 40 kann mobil, insbesondere portabel sein.

Die Prüfvorrichtung 40 ist eingerichtet, um zum Prüfen der korrekten Verdrahtung des Stromwandlers 20 und des Spannungswandlers 10 sowie der korrekten Einbaurichtung des Stromwandlers 20 die erste Signalquelle 41 und die zweite Signalquelle so zu steuern, dass gleichzeitig ein erstes Prüfsignal an die Sekundärverdrahtung 15 des Spannungswandlers 10 angelegt und ein zweites Prüfsignal an der Primärseite des Stromwandlers 20 eingespeist werden. Die Prüfvorrichtung 40 kann eine elektronische Recheneinrichtung 50 aufweisen, die eingerichtet ist, um die erste Signalquelle 41 und die zweite Signalquelle 42 zu steuern. Die elektronische Recheneinrichtung 50 kann eingerichtet sein, um die erste Signalquelle 41 und die zweite Signalquelle 42 so zu steuern, dass sie gleichphasige Wechselsignale ausgeben. Die elektronische Recheneinrichtung kann einen Prozessor, einen Controller, einen Mikroprozessor oder eine Kombination der genannten Einheiten oder andere integrierte Halbleiterschaltungen umfassen.

Die Prüfvorrichtung 40 kann auch nur eine Signalquelle umfassen, die eingerichtet ist, um sowohl das erste Prüfsignal als auch das zweite Prüfsignal zu erzeugen. Die Prüfvorrichtung 40 kann zwei oder mehr Signalquellen umfassen und kann eingerichtet sein, um Prüfsignale gleichzeitig in die Primärseiten von wenigstens zwei Stromwandlern einzuspeisen und an der Sekundärverdrahtung von wenigstens zwei Spannungswandlern anzulegen.

Die elektronische Recheneinrichtung 50 kann eingerichtet sein, um die erwartete Antwort der Sekundäreinrichtung 30 auf das erste Prüfsignal und das zweite Prüfsignal zu simulieren. Dazu kann beispielsweise ein Vorzeichen einer von der Sekundäreinrichtung 30 ermittelten Leistung, ein Auslöseverhalten eines Schutzrelais oder eine andere charakteristische Größe, die das Verhalten der Sekundäreinrichtung 30 als Antwort auf das erste Prüfsignal und das zweite Prüfsignal beschreibt, von der elektronischen Recheneinrichtung 50 ermittelt werden. Dazu kann die elektronische Recheneinrichtung 50 beispielsweise die Leistung, die von der Sekundäreinrichtung bei richtiger Sekundärverdrahtung der Wandler 10, 20 erfasst werden sollte, ermitteln, wie bereits ausführlicher beschrieben wurde.

Die elektronische Recheneinrichtung 50 kann eine Ausgabeschnittstelle 51 aufweisen. Über die Ausgabeschnittstelle 51 kann Information über die rechnerisch ermittelte Antwort ausgegeben werden. Beispielsweise kann die Prüfvorrichtung 40 eingerichtet sein, um über die Ausgabeschnittstelle 51 auszugeben, welches Vorzeichen und optional auch welchen Betrag eine auf einer Leistungsanzeige 31 der Sekundäreinrichtung 30 angezeigte Leistung aufweisen sollte, die als Reaktion auf das erste Prüfsignal und das zweite Prüfsignal ermittelt wird.

Ein Vergleich der tatsächlichen Antwort der Sekundäreinrichtung 30 mit der von der elektronischen Recheneinrichtung für eine korrekte Sekundärverdrahtung der Wandler vorhergesagten Antwort kann durch einen Benutzer erfolgen. Beispielsweise kann ein Benutzer überprüfen, ob das Vorzeichen der Leistungsanzeige in einer Warte mit dem rechnerisch vorhergesagten Vorzeichen der Leistungsanzeige der Warte übereinstimmt.

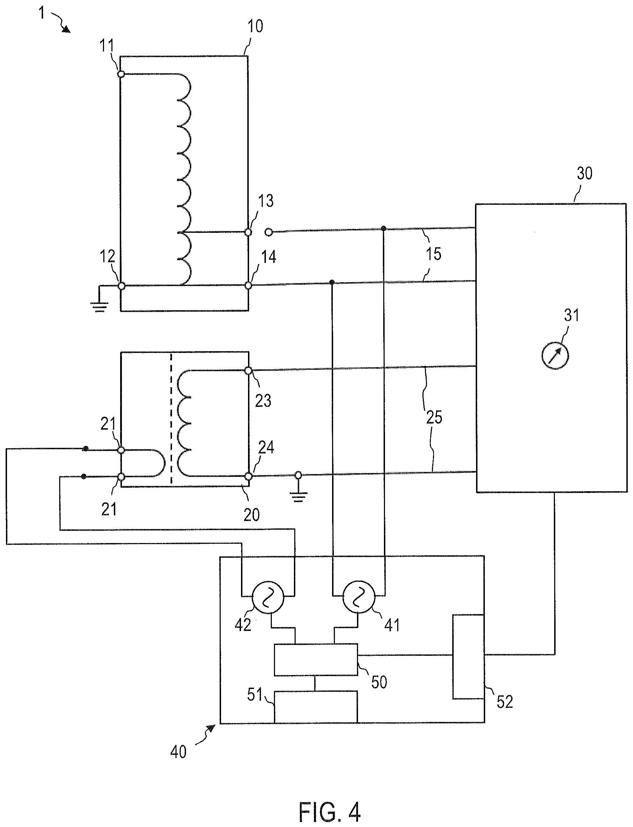

Figur 4 ist eine Darstellung eines Systems 1 nach einem Ausführungsbeispiel, das eine als Prüfgerät ausgestaltete Prüfvorrichtung 40 umfasst, die mit der Primärseite eines Stromwandlers 20 und der Sekundärverdrahtung eines Spannungswandlers 10 leitend verbunden ist. Merkmale, die unter Bezugnahme auf die vorangegangenen Figuren beschriebene Ausgestaltungen und Wirkungen aufweisen können, sind mit denselben Bezugszeichen wie in den vorangegangenen Figuren bezeichnet.

Die Prüfvorrichtung 40 weist eine Eingangsschnittstelle 52 auf. Die Eingangsschnittstelle 52 ist für eine drahtgebundene oder drahtlose Verbindung mit der Sekundäreinrichtung 30 eingerichtet. Die Eingangsschnittstelle 52 ist eingerichtet, um von der Sekundäreinrichtung 30 Information über die Antwort der Sekundäreinrichtung 30 auf das erste Prüfsignal und das zweite Prüfsignal abzurufen.

Die elektronische Recheneinrichtung 50 ist mit der Eingangsschnittstelle 52 gekoppelt und ist eingerichtet, um abhängig von der über die Eingangsschnittstelle 52 abgerufenen Information über die Antwort der Sekundäreinrichtung 30 sowie abhängig von Information über das erste Prüfsignal und das zweite Prüfsignal automatisch zu überprüfen, ob die Sekundärverdrahtung 15 des Spannungswandlers 10 und die Sekundärverdrahtung 25 des Stromwandlers 20 korrekt ausgeführt ist.

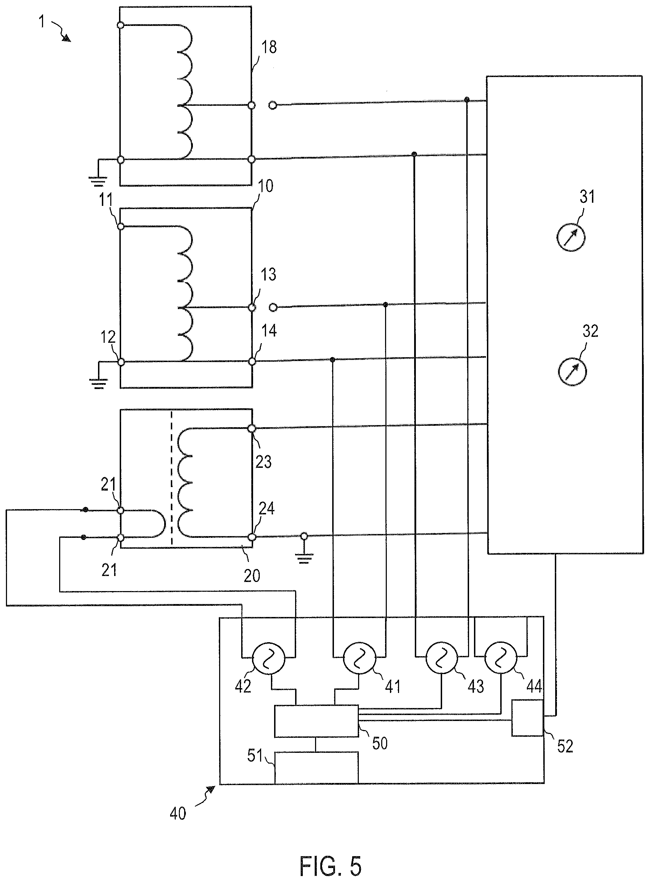

Figur 5 ist eine Darstellung eines Systems 1 nach einem Ausführungsbeispiel, das eine als Prüfgerät ausgestaltete Prüfvorrichtung 40 umfasst, die mit der Primärseite eines Stromwandlers 20 und der Sekundärverdrahtung eines Spannungswandlers 10 leitend verbunden ist. Merkmale, die unter Bezugnahme auf die vorangegangenen Figuren beschriebene Ausgestaltungen und Wirkungen aufweisen können, sind mit denselben Bezugszeichen wie in den vorangegangenen Figuren bezeichnet.

Die Prüfvorrichtung 40 ist eingerichtet, um gleichzeitig Prüfsignale an wenigstens zwei Spannungswandler, die unterschiedlichen Phasen zugeordnet sind, und die mit den jeweiligen Phasen verbundenen Stromwandler anzulegen.

Die Prüfvorrichtung 40 umfasst wenigstens eine Signalquelle 41, 42, die eingerichtet ist, um gleichzeitig das erste Prüfsignal an der Sekundärverdrahtung des Spannungswandlers 10 und das zweite Prüfsignal an der Primärseite des Stromwandlers 20 bereitzustellen. Der Stromwandler 20 ist dabei eingangsseitig mit derselben Phase, beispielsweise der Phase 4 in Figur 1, verbunden wie der Spannungswandler 10.

Die Prüfvorrichtung 40 ist eingerichtet, um gleichzeitig ein weiteres Wechselspannungssignal an der Sekundärverdrahtung eines weiteren Spannungswandlers 18 und ein weiteres Wechselspannungssignal an der Primärseite des mit derselben Phase wie der Spannungswandler 18 verbundenen Stromwandlers anzulegen oder einzuspeisen. Auf diese Weise können gleichzeitig Prüfsignale an wenigstens zwei Stromwandler und an wenigstens zwei Spannungswandler angelegt werden. Die korrekte Verdrahtung und der korrekte Einbau von zwei Spannungswandlern und zwei Stromwandlern kann gleichzeitig in einem Schritt der Prüfung überprüft werden.

Die Prüfvorrichtung 40 kann Ausgänge umfassen, die eingerichtet sind, um gleichzeitig Wechselspannungssignale an die Sekundärverdrahtung von wenigstens zwei Spannungswandlern anzulegen und um gleichzeitig Wechselstromsignal in die Primärseiten von wenigstens zwei Stromwandlern einzuspeisen. Die Prüfvorrichtung 40 kann Ausgänge zur Verbindung mit der Sekundärverdrahtung von zwei, drei oder mehr als drei Spannungswandlern und weitere Ausgänge zur Verbindung mit der Primärseite von zwei, drei oder mehr als drei Stromwandlern aufweisen.

Die Prüfvorrichtung 40 kann wenigstens eine weitere Wechselspannungsquelle 43 umfassen. Die Wechselspannungsquelle 41 und die wenigstens eine weitere Wechselspannungsquelle 43 können eingerichtet sein, um gleichzeitig Wechselspannungssignale als Prüfsignale an der Sekundärverdrahtung von zwei unterschiedlichen Spannungswandlers 10, 18 anzulegen, deren Primärseiten mit unterschiedlichen Phasen des Primärsystems verbunden sind.

Die Prüfvorrichtung 40 kann wenigstens eine weitere Wechselstromquelle 44 umfassen. Die Wechselstromquelle 42 und die wenigstens eine weitere Wechselstromquelle 44 können eingerichtet sein, um gleichzeitig Wechselstromsignale als Prüfsignale an der Primärseite von zwei unterschiedlichen Stromwandlers 20, 28 anzulegen, deren Primärseiten mit unterschiedlichen Phasen des Primärsystems verbunden sind.

Die elektronische Recheneinrichtung 50 der Prüfvorrichtung 40 kann eingerichtet sein, um die Signalquellen zur Prüfung der Verdrahtung von Wandlern, die mit unterschiedlichen Phasen des Primärsystems verbunden sind, so zu steuern, dass sie gleichzeitig oder sequentiell Prüfsignale erzeugen. Dabei werden vorteilhaft Prüfsignale an ein, zwei oder drei Paare von Strom- und Spannungswandlern gleichzeitig angelegt, die mit unterschiedlichen Phasen des Primärsystems verbunden sind.

Wenn gleichzeitig Prüfsignale für Wandler, die mit wenigstens zwei unterschiedlichen Phasen verbunden sind, erzeugt werden, kann die elektronische Recheneinrichtung 50 die Signalquellen 41-44 derart steuern, dass an unterschiedliche Stromwandler und/oder an unterschiedliche Spannungswandler Prüfsignale mit unterschiedlichen Amplituden ausgegeben werden. Beispielsweise kann die elektronische Recheneinrichtung 50 eingerichtet sein, um die Signalquelle 41-44 so zu steuern, dass das an die Sekundärverdrahtung des weiteren Spannungswandlers 18 angelegte Wechselspannungssignal eine Amplitude aufweist, die kleiner ist als die Amplitude des an die Sekundärverdrahtung des Spannungswandlers 10 angelegten ersten Prüfsignals. Alternativ oder zusätzlich kann die elektronische Recheneinrichtung 50 eingerichtet sein, um die Signalquellen 41-44 so zu steuern, dass das in die Primärseite des weiteren Stromwandlers 28 eingespeiste Wechselstromsignal eine Amplitude aufweist, die kleiner ist als die Amplitude des in die Primärseite des Stromwandlers 20 eingespeisten zweiten Prüfsignals.

Die elektronische Recheneinrichtung 50 kann eingerichtet sein, um die Signalquellen 41-44 so zu steuern, dass bei gleichzeitiger Erzeugung von Prüfsignalen für Wandler, die mit unterschiedlichen Phasen verbunden sind, das Produkt aus der Amplitude des an die Sekundärverdrahtung des Spannungswandlers angelegten Wechselspannungssignals und der Amplitude des in die Primärseite des derselben Phase zugeordneten Stromwandlers eingeprägten Wechselstromsignals davon abhängt, mit welcher Phase des Primärsystems der Stromwandler und der Spannungswandler eingangsseitig verbunden sind.

Alternativ oder zusätzlich zu einer Veränderung der Amplitude von Phase zu Phase kann die elektronische Recheneinrichtung 50 auch eingerichtet sein, um die Signalquelle 41-44 so zu steuern, dass eine Phasendifferenz zwischen dem an die Sekundärverdrahtung des Spannungswandlers angelegten Wechselspannungssignal und dem in die Primärseite des derselben Phase zugeordneten Wandlers eingeprägten Wechselstromsignals davon abhängt, mit welcher Phase des Primärsystems der Stromwandler und der Spannungswandler eingangsseitig verbunden sind.

Die elektronische Recheneinrichtung 50 kann eingerichtet sein, um die Signalquellen 41-44 so zu steuern, dass für jede der Phasen das an die Sekundärverdrahtung des Spannungswandlers angelegte Wechselspannungssignal und das in die Primärseite des derselben Phase zugeordneten Stromwandlers eingeprägte Wechselstromsignal dieselbe Frequenz aufweisen. Die elektronische Recheneinrichtung 50 kann eingerichtet sein, um die Signalquellen 41-44 so zu steuern, dass für jede der Phasen das an die Sekundärverdrahtung des Spannungswandlers angelegte Wechselspannungssignal und das in die Primärseite des derselben Phase zugeordneten Stromwandlers eingeprägte Wechselstromsignal gleichphasig sind.

Die elektronische Recheneinrichtung 50 kann eingerichtet sein, um die Signalquellen 41-44 so zu steuern, dass die Wechselspannungssignale gegeneinander phasenverschoben sind, die an der Sekundärverdrahtung von Spannungswandlern 10, 18 angelegt werden, welche unterschiedlichen Phasen zugeordnet sind. Beispielsweise kann das Wechselspannungssignal, das von der Wechselspannungsquelle 43 an der Sekundärverdrahtung des weiteren Spannungswandlers 18 angelegt wird, gegenüber dem Wechselspannungssignal, das von der Wechselspannungsquelle 41 an der Sekundärverdrahtung des Spannungswandlers 10 angelegt wird, um +120° oder um -120° phasenverschoben sein.

Zusätzlich kann die elektronische Recheneinrichtung 50 eingerichtet sein, um die Signalquellen 41-44 so zu steuern, dass die Wechselstromsignale gegeneinander phasenverschoben sind, die in die Primärseiten von Stromwandlern 20, 28 eingespeist werden, welche unterschiedlichen Phasen zugeordnet sind. Beispielsweise kann das Wechselstromssignal, das von der Wechselstromsquelle 44 in die Primärseite des weiteren Stromswandlers 28 eingespeist wird, gegenüber dem Wechselstromssignal, das von der Wechselstromsquelle 42 in die Primärseite des Stromswandlers 20 eingespeist wird, um +120° oder um -120° phasenverschoben sein.

Wenn gleichzeitig Prüfsignale für Wandler erzeugt werden, die mit allen drei Phasen 4, 5, 6 verbunden sind, können die an die Sekundärverdrahtung unterschiedlicher Spannungswandler angelegten Wechselspannungssignale jeweils um +120° oder um -120° gegeneinander phasenverschoben sein. Die in die Primärseiten der entsprechenden Stromwandler eingespeisten Wechselstromsignale können entsprechend jeweils um +120° oder um -120° gegeneinander phasenverschoben sein. Die Prüfsignale, die an mit derselben Phase verbundene Spannungs- und Stromwandler bereitgestellt werden, können jeweils gleichphasig sein.

Die hier beschriebenen Ausgestaltungen einer Prüfvorrichtung und eines Prüfverfahrens, bei denen gleichzeitig Prüfsignale an mit unterschiedlichen Phasen verbundene Wandler bereitgestellt werden, erleichtern die Zuordnung von den für die unterschiedlichen Phasen erwarteten Antworten der Sekundäreinrichtung 30 und den jeweiligen tatsächlichen Antworten der Sekundäreinrichtung 30. Beispielsweise kann mehr als eine Leistungsanzeige 31, 32 ausgelesen werden. Die erwartete und tatsächliche Antwort kann durch einen Benutzer oder automatisch durch die Prüfvorrichtung 40 verglichen werden, um Verdrahtungsfehler und einen Einbau von Stromwandlern mit Polaritätsfehler zu erkennen.

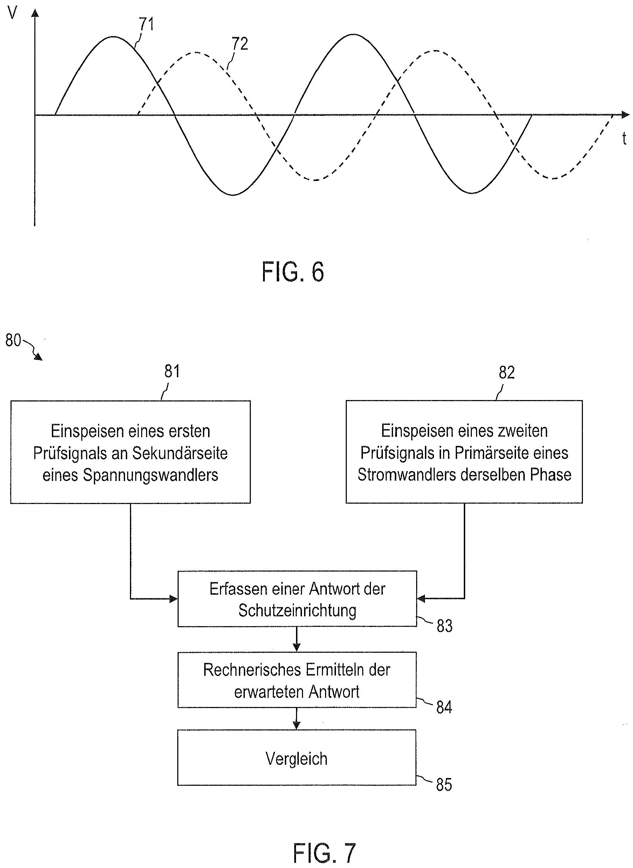

Figur 6 zeigt beispielhaft Prüfsignale 71, 72, die von der Prüfvorrichtung 40 gleichzeitig an die Sekundärverdrahtung von Spannungswandlern, deren Primärseiten mit unterschiedlichen Phasen 4, 5, 6 verbunden sind, angelegt werden können.

Die Prüfsignale 71, 72 können jeweils Wechselspannungssignale sein, die dieselbe Frequenz aufweisen können. Das Prüfsignal 71, das an die Sekundärverdrahtung des mit einer ersten Phase 4 verbundenen Spannungswandlers 10 angelegt wird, weist eine erste Amplitude auf. Das weitere Prüfsignal 72, das an die Sekundärverdrahtung des mit einer von der ersten Phase verschiedenen Phase 5, 6 verbundenen Spannungswandlers 18, 19 angelegt wird, weist eine zweite Amplitude auf. Die zweite Amplitude ist von der ersten Amplitude verschieden.

Alternativ oder zusätzlich zur Verwendung unterschiedlicher Amplituden von Wechselspannungssignalen, die an die Sekundärverdrahtung unterschiedlicher Spannungswandler angelegt werden, können auch die Amplituden der Wechselstromsignale, die in die Primärseiten unterschiedlicher Stromwandler eingespeist werden, verschieden gewählt sein.

Wie ebenfalls in Figur 6 dargestellt ist, kann das weitere Prüfsignal 72, das an die Sekundärverdrahtung des mit einer von der ersten Phase verschiedenen Phase 5, 6 verbundenen Spannungswandlers 18, 19 angelegt wird, eine Phasenverschiebung von +120° oder von -120° relativ zu dem Prüfsignal 71, das an die Sekundärverdrahtung des mit einer ersten Phase 4 verbundenen Spannungswandlers 10 angelegt wird, aufweisen.

Die Wechselstromsignale, die in die Primärseiten der mit unterschiedlichen Phasen verbundenen Stromwandler eingespeist werden, können ebenfalls eine Phasenverschiebung von +120° oder von -120° relativ zueinander aufweisen.

Figur 7 ist ein Flussdiagramm 80 eines Verfahrens nach einem Ausführungsbeispiel. Das Verfahren kann unter Verwendung der Prüfvorrichtung 40 nach einem Ausführungsbeispiel, insbesondere unter Verwendung einer Prüfvorrichtung 40 mit einer der unter Bezugnahme auf die vorgegangenen Figuren beschriebenen Ausgestaltung, ausgeführt werden.

Das Verfahren kann zur Prüfung der Verdrahtung wenigstens eines Stromwandlers und wenigstens eines Spannungswandlers verwendet werden, deren Primärseiten mit einer Phase eines Primärsystems verbunden sind. Die Sekundärseiten des Stromwandlers und des Spannungswandlers können mit Eingängen einer Schutzeinrichtung, einer Messeinrichtung, einer Warte oder einer anderen Sekundäreinrichtung verbunden sein.

Bei 81 wird ein erstes Prüfsignal an der Sekundärseite eines Spannungswandlers angelegt. Das erste Prüfsignal kann an der Sekundärverdrahtung, die den Spannungswandler mit Eingängen der Sekundäreinrichtung 30 verbindet, angelegt werden. Das erste Prüfsignal kann ein Wechselspannungssignal sein. Die Sekundärverdrahtung kann bei der Prüfung an der Sekundärseite des Spannungswandlers abgeklemmt sein.

Bei 82 wird gleichzeitig mit dem ersten Prüfsignal ein zweites Prüfsignal erzeugt. Das zweite Prüfsignal wird in die Primärseite des Stromwandlers eingeprägt, der eingangsseitig mit derselben Phase des Primärsystems verbunden ist wie der Spannungswandler. Das zweite Prüfsignal kann ein Wechselstromsignal sein. Das zweite Prüfsignal kann gleichphasig mit dem ersten Prüfsignal sein.

Bei 83 wird eine Antwort der Sekundäreinrichtung, die beispielsweise ein Schutzrelais umfassen kann, erfasst. Das Erfassen der Antwort kann ein Auslesen eines Vorzeichens und optional auch eines Betrags einer von der Sekundäreinrichtung ermittelten Leistung umfassen, die die Sekundäreinrichtung als Antwort auf das erste Prüfsignal und das zweite Prüfsignal ermittelt. Das Erfassen der Antwort kann ein Erfassen einer Zeitdauer, in der ein Schutzrelais einen Leistungsschalter ausschaltet, umfassen. Das Erfassen der Antwort kann ein Auslesen einer Leistungsanzeige in einer Warte umfassen.

Bei 84 kann eine erwartete Antwort der Schutzeinrichtung simuliert werden. Dazu kann ein Vorzeichen einer Leistung rechnerisch ermittelt werden, der von der Sekundäreinrichtung erfasst werden sollte, wenn der Stromwandler ohne Polaritätsfehler eingebaut und sowohl der Stromwandler als auch der Spannungswandler fehlerfrei mit der Schutzeinrichtung verdrahtet sind. Optional kann ein Betrag einer Leistung rechnerisch ermittelt werden, der von der Sekundäreinrichtung erfasst werden sollte, wenn der Stromwandler ohne Polaritätsfehler eingebaut und sowohl der Stromwandler als auch der Spannungswandler fehlerfrei mit der Schutzeinrichtung verdrahtet sind. Falls gleichzeitig Prüfsignale in die Wandler mehrerer Phasen eingespeist werden, können auch relative Größen der Leistungsbeträge rechnerisch ermittelt werden, die man erwartet, wenn die Stromwandler ohne Polaritätsfehler eingebaut und sowohl die Stromwandler als auch die Spannungswandler fehlerfrei mit der Schutzeinrichtung verdrahtet sind.

Bei 85 kann die erwartete Antwort mit der tatsächlich erfassten Antwort verglichen werden. Bei einer Übereinstimmung kann auf einen korrekten Einbau des Stromwandlers ohne Polaritätsfehler und auf eine korrekte Verdrahtung der Wandler mit den Eingängen der Schutzeinrichtung geschlossen werden. Bei einer Abweichung kann ermittelt werden, dass ein Verdrahtungsfehler vorliegt oder der Stromwandler mit falscher Polarität eingebaut wurde. Beispielsweise kann auf einen derartigen Fehler geschlossen werden, wenn das Vorzeichen der von der Schutzeinrichtung ermittelten Leistung entgegengesetzt zu einem für das erste und zweite Prüfsignal erwarteten Vorzeichen der Leistung ist.

Zusätzlich zur Prüfung der Verdrahtung kann mit dem Verfahren auch ermittelt werden, ob Einstellungen innerhalb der Sekundäreinrichtung 30 korrekt gesetzt und/oder die Wandler an die der entsprechenden Phase zugeordneten Eingänge der Sekundäreinrichtung 30 angeschlossen sind. Beispielsweise kann überprüft werden, ob das Einspeisen von Prüfsignalen an den Wandlern, die mit einer ersten Phase 4 des Primärsystems verbunden sind, auch zu einer entsprechenden Leistungsanzeige in einer Warte führt, oder ob die Leistung fehlerhaft für eine andere Phase 5, 6 des Primärsystems angezeigt wird.

Die Verdrahtung und der korrekte Einbau von Wandlern, deren Primärseite mit unterschiedlichen Phasen des Primärsystems gekoppelt ist, kann sequentiell oder gleichzeitig überprüft werden.

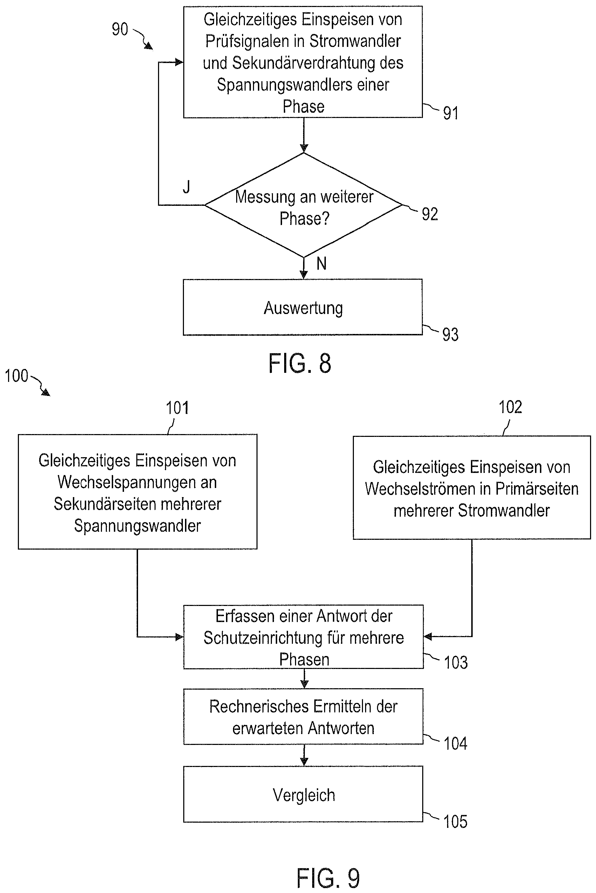

Figur 8 ist ein Flussdiagramm 90 eines Verfahrens nach einem Ausführungsbeispiel. Das Verfahren kann unter Verwendung der Prüfvorrichtung 40 nach einem Ausführungsbeispiel, insbesondere unter Verwendung einer Prüfvorrichtung 40 mit einer der unter Bezugnahme auf die vorgegangenen Figuren beschriebenen Ausgestaltung, ausgeführt werden.

Das Verfahren kann verwendet werden, um die Verdrahtung von Strom- und Spannungswandlern sequentiell für mehrere Phasen zu prüfen.

Bei 91 werden gleichzeitig ein erstes Prüfsignal an der Sekundärverdrahtung eines Spannungswandlers, dessen Eingangsseite mit einer Phase des Primärsystems verbunden ist, angelegt und ein zweite Prüfsignal in die Primärseite des Stromwandlers, der mit derselben Phase verbunden ist, eingespeist. Dies kann wie unter Bezugnahme auf Schritte 81 und 82 des Verfahrens von Figur 7 beschrieben erfolgen.

Die Antwort der Sekundäreinrichtung auf das erste Prüfsignal und das zweite Prüfsignal kann erfasst werden. Dies kann wie unter Bezugnahme auf Schritt 83 des Verfahrens von Figur 7 beschrieben erfolgen.

Bei 92 kann überprüft werden, ob die Messungen bereits an den Wandlern aller Phasen ausgeführt wurden. Falls die Messung noch nicht an den Wandlern aller Phasen ausgeführt wurde, kehrt das Verfahren zu Schritt 91 zurück. Die Prüfsignale werden nunmehr in die Sekundärverdrahtung eines Spannungswandlers und die Primärseite eines Stromwandlers eingespeist, die mit einer anderen Phase des Primärsystems verbunden sind.

Falls bei Schritt 92 ermittelt wird, dass die Messungen an den Wandlern aller Phasen ausgeführt wurden, fährt das Verfahren bei Schritt 93 fort. Bei 93 kann überprüft werden, ob die Antwort der Sekundäreinrichtung, die jeweils als Reaktion auf das erste Prüfsignal und das zweite Prüfsignal für jedes Paar von Wandlern erfasst wurde, mit der erwarteten Antwort übereinstimmt. Auf diese Weise kann ermittelt werden, ob Verdrahtungs- oder Polaritätsfehler vorliegen. Zusätzlich kann ermittelt werden, an welchem Paar aus Strom- und Spannungswandler der entsprechende Fehler vorliegt.

Figur 9 ist ein Flussdiagramm 100 eines Verfahrens nach einem Ausführungsbeispiel. Das Verfahren kann unter Verwendung der Prüfvorrichtung 40 nach einem Ausführungsbeispiel, insbesondere unter Verwendung einer Prüfvorrichtung 40 mit einer der unter Bezugnahme auf die vorgegangenen Figuren beschriebenen Ausgestaltung, ausgeführt werden.

Das Verfahren kann verwendet werden, um die Verdrahtung von Strom- und Spannungswandlern für mehrere Phasen gleichzeitig in einer Messung zu prüfen. Die mehreren Strom- und Spannungswandler sind dabei zwischen drei Phasen einer Dreiphasenleitung und die Sekundäreinrichtung, beispielsweise ein Schutzrelais, geschaltet. Zur Prüfung können die Sekundärseiten der Spannungswandler jeweils an nur einer Klemme abgeklemmt werden.

Bei 101 werden gleichzeitig Wechselspannungssignale an den Sekundärseiten mehrerer Spannungswandler angelegt. Jedes der Wechselspannungssignale kann an der Sekundärverdrahtung, die jeweils einen Spannungswandler mit Eingängen der Sekundäreinrichtung 30 verbindet, angelegt werden. Die Sekundärverdrahtung kann bei der Prüfung an der Sekundärseite des Spannungswandlers an einer Klemme abgeklemmt sein.

Die unterschiedlichen Wechselspannungen können voneinander verschiedene Amplituden aufweisen. Die unterschiedlichen Wechselspannungen können gegeneinander phasenverschoben sein. Die unterschiedlichen Wechselspannungen können eine Phasenverschiebung von +120° oder von -120° zueinander aufweisen.

Bei 102 werden gleichzeitig mit dem Anlegen der Wechselspannungen mehrere Wechselstromsignale in die Primärseiten mehrerer Stromwandler eingespeist. Dabei kann eine Einspeisung eines Wechselstroms in die Primärseite jedes Stromwandlers erfolgen, wenn an der Sekundärverdrahtung des mit derselben Phase verbundenen Spannungswandlers eine Wechselspannung angelegt wird. Das Wechselstromsignal, das in einen Stromwandler eingeprägt wird, kann gleichphasig sein mit dem Wechselspannungssignal, das an der Sekundärverdrahtung des mit derselben Phase verbundenen Spannungswandlers angelegt wird.

Die unterschiedlichen Wechselströme können voneinander verschiedene Amplituden aufweisen. Die unterschiedlichen Wechselströme können gegeneinander phasenverschoben sein. Die unterschiedlichen Wechselströme können eine Phasenverschiebung von +120° oder von -120° zueinander aufweisen.

Bei 103 wird eine Antwort der Sekundäreinrichtung, die beispielsweise ein Schutzrelais umfassen kann, erfasst. Das Erfassen der Antwort kann ein Auslesen eines Vorzeichens und optional auch eines Betrags mehrerer von der Sekundäreinrichtung ermittelten Leistungen umfassen, die die Sekundäreinrichtung als Antwort auf die Wechselspannungssignale und die Wechselstromsignale für die unterschiedlichen Phasen ermittelt. Das Erfassen der Antwort kann ein Erfassen einer Zeitdauer, in der ein Schutzrelais einen Leistungsschalter ausschaltet, umfassen. Das Erfassen der Antwort kann ein Auslesen einer Leistungsanzeige in einer Warte für mehrere Phasen umfassen.

Bei 104 kann eine erwartete Antwort der Schutzeinrichtung simuliert werden. Die Bestimmung der erwarteten Antwort kann wie bei Schritt 84 des Verfahrens von Figur 7 erfolgen, wobei erwartete Leistungen beispielsweise separat für mehrere Phasen ermittelt werden können.

Bei 105 kann die erwartete Antwort mit der tatsächlich erfassten Antwort verglichen werden. Dazu kann beispielsweise für jede der drei Phasen ein Vorzeichen einer von der Schutzeinrichtung jeweils ermittelten Leistung mit demjenigen Vorzeichen verglichen werden, das als Reaktion auf die Wechselspannung und den Wechselstrom bei korrekter Verdrahtung der Wandler erwartet wird. Dieser Vergleich kann für jede der drei Phasen ausgeführt werden. Bei einer Übereinstimmung kann auf einen korrekten Einbau des Stromwandlers ohne Polaritätsfehler und auf eine korrekte Verdrahtung der Wandler mit den Eingängen der Schutzeinrichtung geschlossen werden. Bei einer Abweichung kann ermittelt werden, dass ein Verdrahtungsfehler vorliegt oder der Stromwandler mit falscher Polarität eingebaut wurde. Beispielsweise kann auf einen derartigen Fehler geschlossen werden, wenn das Vorzeichen der von der Schutzeinrichtung ermittelten Leistung entgegengesetzt zu einem für das erste und zweite Prüfsignal erwarteten Vorzeichen der Leistung ist.

Zusätzlich zur Prüfung der Verdrahtung kann mit dem Verfahren auch ermittelt werden, ob Einstellungen innerhalb der Sekundäreinrichtung 30 korrekt gesetzt und/oder die Wandler an die der entsprechenden Phase zugeordneten Eingänge der Sekundäreinrichtung 30 angeschlossen sind. Beispielsweise kann anhand der unterschiedlichen Amplituden der Wechselspannungen und/oder Wechselströme, die als Prüfsignale eingeprägt werden, überprüft werden, ob das Einspeisen von Prüfsignalen an den Wandlern, die mit einer ersten Phase 4 des Primärsystems verbunden sind, auch zu der entsprechenden Leistungsanzeige in einer Warte führt, oder ob diese Leistung fehlerhaft für eine andere Phase 5, 6 des Primärsystems angezeigt wird.

Während Verfahren, Vorrichtungen und Systeme unter Bezugnahme auf die Figuren detailliert beschrieben wurde, können zusätzliche oder alternative Merkmale bei Ausführungsbeispielen verwendet werden. Beispielsweise kann die Prüfvorrichtung 40 derart eingerichtet sein, dass eine Amplitude und/oder Frequenz wenigstens des in die Primärseite des Stromwandlers eingespeisten zweiten Prüfsignals zeitabhängig verändert wird, um ein Aufmagnetisieren des Stromwandlers zu vermeiden.

Während Ausführungsbeispiele beschrieben wurden, bei denen sinusförmige Wechselsignale als Prüfsignale eingesetzt wurden, können auch andere Wechselsignale, beispielsweise rechteckförmige oder dreieckförmige Signale, oder Gleichspannungsund Gleichstromsignale als Prüfsignale verwendet werden.

Die Verfahren, Vorrichtungen und Systeme können eingesetzt werden, um einen fehlerhaften Einbau von Stromwandlern und/oder eine fehlerhafte Verdrahtung zwischen Wandlern und den Eingängen der Einrichtung des Sekundärsystems zu detektieren. Zusätzlich können mit den offenbarten Verfahren, Vorrichtungen und Systemen auch Einstellungen innerhalb der Einrichtung des Sekundärsystems überprüft werden. Beispielsweise kann anhand des Auslöseverhaltens eines Schutzrelais überprüft werden, ob ein rasches Abschalten bei einem Fehlerfall erfolgt, der in einer vordefinierten Richtung, beispielsweise auf einer Freileitung, relativ zu dem Schutzrelais auftritt.

Vorrichtung, Verfahren und Systeme nach Ausführungsbeispielen sind insbesondere für Sekundäreinrichtungen einsetzbar, die sowohl über einen oder mehrere Stromwandler als auch über einen oder mehrere Spannungswandler mit dem Primärsystem eines Energienetzes, eines Umspannwerks oder eines Kraftwerks gekoppelt sind, um Überwachungs- und/oder Schutzfunktionen auszuführen.

Vorrichtung, Verfahren und Systeme nach Ausführungsbeispielen verringern das Risiko, dass es aufgrund eines fehlerhaften Einbaus oder einer fehlerhaften Verdrahtung von Strom- und Spannungswandlern, die mit einem Schutzrelais oder einer anderen Einrichtung des Sekundärsystems verbunden sind, zu Fehlerfällen in einem elektrischen Energiesystem kommen kann.

## Patentansprüche

1. Verfahren zum Prüfen einer Verdrahtung wenigstens eines Stromwandlers (20, 28, 29) und wenigstens eines Spannungswandlers (10, 18, 19) einer Einrichtung (30) eines elektrischen Energiesystems (1), umfassend
Anlegen eines ersten Prüfsignals (71) an einer Sekundärseite (15) eines Spannungswandlers (10) und
Einprägen eines zweiten Prüfsignals in eine Primärseite eines Stromwandlers (20), wobei das erste Prüfsignal (71) und das zweite Prüfsignal gleichzeitig erzeugt werden, und
Auswerten einer Antwort der Einrichtung (30) auf das erste Prüfsignal (71) und das zweite Prüfsignal.

2. Verfahren nach Anspruch 1, wobei das Auswerten der Antwort der Einrichtung (30) umfasst:
Berechnen einer erwarteten Antwort abhängig von einer Amplitude des ersten Prüfsignals (71), einer Amplitude des zweiten Prüfsignals und einer Phasenlage zwischen dem ersten Prüfsignal und dem zweiten Prüfsignal.

3. Verfahren nach Anspruch 1 oder Anspruch 2,
wobei die Antwort der Einrichtung (30) ein Vorzeichen und/oder einen Betrag einer von der Einrichtung erfasste Leistung umfasst.

4. Verfahren nach einem der vorhergehenden Ansprüche,
wobei das erste Prüfsignal (71) eine Wechselspannung ist und wobei das zweite Prüfsignal ein Wechselstrom ist.

5. Verfahren nach einem der vorhergehenden Ansprüche,
wobei das erste Prüfsignal und das zweite Prüfsignal gleichphasig sind.

6. Verfahren nach einem der vorhergehenden Ansprüche,
wobei das erste Prüfsignal (71) an der Sekundärseite des Spannungswandlers (10) angelegt wird, der einer ersten Phase (4) von mehreren Phasen (4-6) zugeordnet ist, und
wobei das zweite Prüfsignal in die Primärseite des Stromwandlers (20) eingeprägt wird, der mit der ersten Phase (4) verbunden ist.

7. Verfahren nach Anspruch 6, weiterhin umfassend:
Erzeugen wenigstens eines weiteren Prüfsignals (72) zum Prüfen der Verdrahtung wenigstens eines weiteren Wandlers (18, 19, 28, 29), der mit einer von der ersten Phase (4) verschiedenen weiteren Phase (5, 6) einer Mehrphasenleitung verbunden ist, wobei vorzugsweise das wenigstens eine weitere Prüfsignal (72) gleichzeitig mit dem ersten Prüfsignal (71) und dem zweiten Prüfsignal erzeugt wird.

8. Verfahren nach einem der vorhergehenden Ansprüche,
wobei das erste Prüfsignal (71) und wenigstens ein weiteres Wechselspannungssignal (72) an der Sekundärseite von wenigstens zwei Spannungswandlern (10, 18) der Einrichtung, die unterschiedlichen Phasen (4, 5) zugeordnet sind, gleichzeitig angelegt werden, wobei vorzugsweise das erste Prüfsignal (71) und das wenigstens eine weitere Wechselspannungssignal (72) unterschiedliche Amplituden aufweisen.

9. Verfahren nach einem der vorhergehenden Ansprüche,
wobei das zweite Prüfsignal und wenigstens ein weiteres Wechselstromsignal an der Primärseite von wenigstens zwei Stromwandlern (20, 28) der Einrichtung (30), die unterschiedlichen Phasen (4, 5) zugeordnet sind, gleichzeitig angelegt werden, wobei vorzugsweise das zweite Prüfsignal und das wenigstens eine weitere Wechselstromsignal unterschiedliche Amplituden aufweisen.

10. Verfahren nach einem der vorhergehenden Ansprüche,
wobei die Einrichtung ein Schutzrelais, eine Leistungsanzeige in einer Warte oder eine Messeinrichtung umfasst.

11. Prüfvorrichtung zum Prüfen einer Verdrahtung wenigstens eines Stromwandlers (20, 28, 29) und wenigstens eines Spannungswandlers (10, 18, 19) einer Einrichtung (30) eines elektrischen Energiesystems, umfassend
einen ersten Ausgang zum Anlegen eines ersten Prüfsignals (71) an einer Sekundärseite (15) eines Spannungswandlers (10), und
einen zweiten Ausgang zum Einprägen eines zweiten Prüfsignals in eine Primärseite eines Stromwandlers (20),
wobei die Prüfvorrichtung (40) eingerichtet ist, um das an die Sekundärseite des Spannungswandlers(10) angelegte erste Prüfsignal und das in die Primärseite des Stromwandlers (20) eingeprägt zweite Prüfsignal gleichzeitig zu erzeugen, und
wobei die Prüfvorrichtung (40) eingerichtet ist, um eine Antwort der Einrichtung (30) auf das erste Prüfsignal (71) und das zweite Prüfsignal auszuwerten.

12. Prüfvorrichtung nach Anspruch 11, umfassend
eine elektronische Recheneinrichtung (50), die eingerichtet ist, um eine erwartete Antwort der Einrichtung (30) auf das erste Prüfsignal (71) und das zweite Prüfsignal aus einer Amplitude des ersten Prüfsignals (71), einer Amplitude des zweiten Prüfsignals und einer Phasenbeziehung zwischen dem ersten Prüfsignal (71) und dem zweiten Prüfsignal rechnerisch zu ermitteln.

13. Prüfvorrichtung nach Anspruch 12, umfassend
eine Ausgabeschnittstelle (51) zum Ausgeben der rechnerisch ermittelten erwarteten Antwort und/oder eine Eingangsschnittstelle (52) zum Empfangen der Antwort der Einrichtung (30).

14. Prüfvorrichtung nach einem der Ansprüche 11 bis 13,
wobei die Prüfvorrichtung (40) zur Durchführung des Verfahrens nach einem der Ansprüche 1 bis 10 ausgestaltet ist.

15. System, umfassend
eine Einrichtung (30), die Eingänge aufweist, die mit wenigstens einem Stromwandler (20, 28, 29) und wenigstens einem Spannungswandler (10, 18, 19) leitend verbindbar sind, und
eine Prüfvorrichtung (40) nach einem der Ansprüche 11 bis 14, die mit einer Sekundärverdrahtung (15) eines Spannungswandlers (10) des wenigstens einen Spannungswandlers (10, 18, 19) und mit der Primärseite eines Stromwandlers (20) des wenigstens einen Stromwandlers (20, 28, 29) verbunden ist.

## Claims

1. A method for testing a wiring of at least one current transformer (20, 28, 29) and at least one voltage transformer (10, 18, 19) of a device (30) of an electrical energy system (1), comprising applying a first test signal (71) to a secondary side (15) of a voltage transformer (10) and
impressing a second test signal into a primary side of a current transformer (20),
wherein the first test signal (71) and the second test signal are generated at the same time, and
evaluating a response of the device (30) to the first test signal (71) and the second test signal.

2. The method according to claim 1, wherein the evaluating of the response of the device (30) comprises:
calculating an expected response depending on an amplitude of the first test signal (71), an amplitude of the second test signal and a phase angle between the first test signal and the second test signal.

3. The method according to claim 1 or claim 2,
wherein the response of the device (30) comprises an arithmetic sign and/or an absolute value of a power detected by the device.

4. The method according to any one of the preceding claims,
wherein the first test signal (71) is an AC voltage and wherein the second test signal is an AC current.

5. The method according to any one of the preceding claims,
wherein the first test signal and the second test signal are in phase.

6. The method according to any one of the preceding claims,
wherein the first test signal (71) is applied to the secondary side of the voltage transformer (10) that is associated with a first phase (4) of multiple phases (4-6), and
wherein the second test signal is impressed into the primary side of the current transformer (20) that is connected to the first phase (4).

7. The method according to claim 6, further comprising:
generating at least one further test signal (72) for testing the wiring of at least one further transformer (18, 19, 28, 29) that is connected to a further phase (5, 6), which is different from the first phase (4), of a multiphase line, wherein preferably the at least one further test signal (72) is generated at the same time as the first test signal (71) and the second test signal.

8. The method according to any one of the preceding claims,
wherein the first test signal (71) and at least one further AC voltage signal (72) are applied at the same time to the secondary side of at least two voltage transformers (10, 18) of the device, which are associated with different phases (4, 5), wherein preferably the first test signal (71) and the at least one further AC voltage signal (72) have different amplitudes.

9. The method according to any one of the preceding claims,
wherein the second test signal and at least one further AC current signal are applied at the same time to the primary side of at least two current transformers (20, 28) of the device (30), which are associated with different phases (4, 5), wherein preferably the second test signal and the at least one further AC current signal have different amplitudes.

10. The method according to any one of the preceding claims,
wherein the device comprises a protective relay, a power display in a control room or a measuring device.

11. A testing apparatus for testing a wiring of at least one current transformer (20, 28, 29) and at least one voltage transformer (10, 18, 19) of a device (30) of an electrical energy system, comprising a first output for applying a first test signal (71) to a secondary side (15) of a voltage transformer (10) and
a second output for impressing a second test signal into a primary side of a current transformer (20),
wherein the testing apparatus (40) is configured to generate the first test signal applied to the secondary side of the voltage transformer (10) and the second test signal impressed into the primary side of the current transformer (20) at the same time, and
wherein the testing apparatus (40) is configured to evaluate a response of the device (30) to the first test signal (71) and the second test signal.

12. The testing apparatus according to claim 11, comprising an electronic computation device (50) that is configured to computationally ascertain an expected response of the device (30) to the first test signal (71) and the second test signal from an amplitude of the first test signal (71), an amplitude of the second test signal and a phase relationship between the first test signal (71) and the second test signal.

13. The testing apparatus according to claim 12, comprising an output interface (51) for outputting the computationally ascertained expected response and/or an input interface (52) for receiving the response of the device (30).

14. The testing apparatus according to any one of claims 11 to 13, wherein the testing apparatus (40) is configured for carrying out the method according to any one of claims 1 to 10.

15. A system comprising
a device (30) that has inputs that are conductively connectable to at least one current transformer (20, 28, 29) and at least one voltage transformer (10, 18, 19), and
a testing apparatus (40) according to any one of claims 11 to 14, which is connected to a secondary wiring (15) of a voltage transformer (10) of the at least one voltage transformer (10, 18, 19) and to the primary side of a current transformer (20) of the at least one current transformer (20, 28, 29).

## Revendications

1. Procédé permettant de tester un câblage d'au moins un transformateur de courant (20, 28, 29) et d'au moins un transformateur de tension (10, 18, 19) d'un appareil (30) d'un système d'énergie électrique (1), comprenant
l'application d'un premier signal de test (71) à un côté secondaire (15) d'un transformateur de tension (10) et
l'inscription d'un second signal de test dans un côté primaire d'un transformateur de courant (20), dans lequel le premier signal de test (71) et le second signal de test sont générés simultanément, et
l'évaluation d'une réponse de l'appareil (30) au premier signal de test (71) et au second signal de test.

2. Procédé selon la revendication 1, dans lequel l'évaluation de la réponse de l'appareil (30) comprend :
le calcul d'une réponse attendue en fonction d'une amplitude du premier signal de test (71), d'une amplitude du second signal de test et d'une position de phase entre le premier signal de test et le second signal de test.

3. Procédé selon la revendication 1 ou la revendication 2,
dans lequel la réponse de l'appareil (30) comprend un signe et/ou une quantité d'une puissance enregistrée par l'appareil.

4. Procédé selon l'une des revendications précédentes,
dans lequel le premier signal de test (71) est une tension alternative et dans lequel le second signal de test est un courant alternatif.

5. Procédé selon l'une des revendications précédentes,
dans lequel le premier signal de test et le second signal de test sont en phase.

6. Procédé selon l'une des revendications précédentes,
dans lequel le premier signal de test (71) est appliqué au côté secondaire du transformateur de tension (10), lequel est associé à une première phase (4) de plusieurs phases (4-6), et
dans lequel le second signal de test est inscrit dans le côté primaire du transformateur de courant (20), lequel est relié à la première phase (4).

7. Procédé selon la revendication 6, comprenant en outre : la génération d'au moins un autre signal de test (72) permettant de tester le câblage d'au moins un autre transformateur (18, 19, 28, 29) qui est relié à une autre phase (5, 6) d'une ligne polyphasée différente de la première phase (4), dans lequel, de préférence, l'au moins un autre signal de test (72) est généré simultanément avec le premier signal de test (71) et le second signal de test.

8. Procédé selon l'une des revendications précédentes,
dans lequel le premier signal de test (71) et au moins un autre signal de tension alternative (72) sont appliqués simultanément au côté secondaire d'au moins deux transformateurs de tension (10, 18) de l'appareil, lesquels sont associés à des phases différentes (4, 5), dans lequel, de préférence, le premier signal de test (71) et l'au moins un autre signal de tension alternative (72) présentent des amplitudes différentes.

9. Procédé selon l'une des revendications précédentes,
dans lequel le second signal de test et au moins un autre signal de courant alternatif sont appliqués simultanément au côté primaire d'au moins deux transformateurs de courant (20, 28) de l'appareil (30), lesquels sont associés à des phases différentes (4, 5), dans lequel, de préférence, le second signal de test et l'au moins un autre signal de courant alternatif présentent des amplitudes différentes.

10. Procédé selon l'une des revendications précédentes,
dans lequel l'appareil comprend un relais de protection, un affichage de puissance dans un poste de contrôle ou un appareil de mesure.

11. Dispositif de test permettant de tester un câblage d'au moins un transformateur de courant (20, 28, 29) et d'au moins un transformateur de tension (10, 18, 19) d'un appareil (30) d'un système d'énergie électrique, comprenant
une première sortie permettant d'appliquer un premier signal de test (71) à un côté secondaire (15) d'un transformateur de tension (10), et
une seconde sortie permettant d'inscrire un second signal de test dans un côté primaire d'un transformateur de courant (20),
dans lequel le dispositif de test (40) est configuré pour générer simultanément le premier signal de test appliqué au côté secondaire du transformateur de tension (10) et le second signal de test inscrit sur le côté primaire du transformateur de courant (20), et
dans lequel le dispositif de test (40) est configuré pour évaluer une réponse de l'appareil (30) au premier signal de test (71) et au second signal de test.

12. Dispositif de test selon la revendication 11, comprenant
un appareil de calcul électronique (50) qui est configuré pour déterminer par calcul une réponse attendue de l'appareil (30) au premier signal de test (71) et au second signal de test à partir d'une amplitude du premier signal de test (71), d'une amplitude du second signal de test et d'une relation de phases entre le premier signal de test (71) et le second signal de test.

13. Dispositif de test selon la revendication 12, comprenant
une interface de sortie (51) permettant de sortir la réponse attendue déterminée par calcul et/ou une interface d'entrée (52) permettant de recevoir la réponse de l'appareil (30).

14. Dispositif de test selon l'une des revendications 11 à 13,
dans lequel le dispositif de test (40) est conçu pour mettre en oeuvre le procédé selon l'une des revendications 1 à 10.

15. Système, comprenant
un appareil (30) présentant des entrées qui peuvent être reliées de manière conductrice à au moins un transformateur de courant (20, 28, 29) et à au moins un transformateur de tension (10, 18, 19), et
un dispositif de test (40) selon l'une des revendications 11 à 14, qui est relié à un câblage secondaire (15) d'un transformateur de tension (10) de l'au moins un transformateur de tension (10, 18, 19) et au côté primaire d'un transformateur de courant (20) de l'au moins un transformateur de courant (20, 28, 29).
